(19) Europäisches Patentamt
European Patent Office
Office européen des brevets

(11) EP 4 073 586 B1

(12) **EUROPEAN PATENT SPECIFICATION**

(45) Date of publication and mention of the grant of the patent:
**20.12.2023 Bulletin 2023/51**

(21) Application number: **20821007.0**

(22) Date of filing: **11.12.2020**

(51) International Patent Classification (IPC):
***G03F 7/004*** *(2006.01)* ***G03F 7/38*** *(2006.01)*
***G03F 7/40*** *(2006.01)*

(52) Cooperative Patent Classification (CPC):
**G03F 7/0046; G03F 7/38; G03F 7/40**

(86) International application number:
**PCT/EP2020/085828**

(87) International publication number:
**WO 2021/116442 (17.06.2021 Gazette 2021/24)**

(54) **METHOD FOR REMOVING FLUOROPOLYMER LIFT-OFF LAYER**

VERFAHREN ZUM ENTFERNEN EINER FLUORPOLYMERABHEBESCHICHT

PROCÉDÉ D'ÉLIMINATION DE COUCHE DE DÉCOLLEMENT DE FLUOROPOLYMÈRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.12.2019 EP 19215451**

(43) Date of publication of application:
**19.10.2022 Bulletin 2022/42**

(73) Proprietor: **Solvay Specialty Polymers Italy S.p.A.**
**20021 Bollate (MI) (IT)**

(72) Inventors:
- **LEE, Jung-Yul**
  **Anyang-si, Gyeonggi-do 13924 (KR)**
- **CHOE, Dong-Cheol**
  **Incheon 21956 (KR)**
- **YOON, Min-Soo**
  **Seoul (KR)**
- **PONTA, Laura**
  **20159 Milano MI (IT)**
- **BASSI, Mattia**
  **20144 Milano MI (IT)**

(74) Representative: **Benvenuti, Federica**
**Solvay S.A.**
**Intellectual Assets Management**
**Rue de la Fusée, 98**
**1130 Haren (BE)**

(56) References cited:
**EP-A1- 2 143 818**
**WO-A1-2016/019212**
**WO-A1-2016/019273**
**WO-A2-2009/126916**
**JP-A- 2010 131 569**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 073 586 B1

## Description

### Technical Field

The present invention pertains to a method of removing a layer of a lift-off fluoropolymer from a substrate using a particular stripping solvent, and to a lithographic process using said combination of lift-off fluoropolymer and stripping solvent.

### Background Art

Fluoropolymers have been already used in the past in lithographic processes, and more specifically as protective layers in certain photolithographic methods, whereas the creation of a sacrificial fluoropolymer layer is required for protecting/preserving chemical integrity of substrate during either radiation exposure of photoresist(s) and/or etching of photoresist(s) layers.

Document US9899636 discloses a method of making an OLED device which includes:

a) providing a device substrate having a first array of bottom electrodes and a second array of bottom electrodes;
b) providing a first undercut lift-off structure over the device substrate having a first pattern of openings corresponding to the first array of bottom electrodes;
c) depositing one or more first organic EL medium layers including at least a first light-emitting layer over the first undercut lift-off structure and over the first array of bottom electrodes;
d) removing the first undercut lift-off structure and overlying first organic EL medium layer(s) by treatment with a first lift-off agent comprising a fluorinated solvent to form a first intermediate structure;
e) providing a second undercut lift-off structure over the first intermediate structure having a second pattern of openings corresponding to the second array of bottom electrodes;
f) depositing one or more second organic EL medium layers including at least a second light-emitting layer over the second undercut lift-off structure and over the second array of bottom electrodes;
g) removing the second undercut lift-off structure and overlying second organic EL medium layer(s) by treatment with a second lift-off agent comprising a fluorinated solvent to form a second intermediate structure; and
h) providing a common top electrode in electrical contact with the first and second organic EL medium layers.

The undercut lift-off structure includes a fluorinated material base layer and an overlying photoresist layer developed using a fluorinated solvent selected from those that are perfluorinated or highly fluorinated liquids at room temperature, which are immiscible with water and many organic solvents. Among those solvents, hydrofluoroethers (HFEs), including segregated HFEs, are recommended as preferred solvents because they are non-flammable, have zero ozone-depletion potential, lower global warming potential than PFCs and show very low toxicity to humans.

Similarly, document US9768384 discloses a method of manufacturing an organic light-emitting display apparatus including forming a liftoff layer containing a fluoropolymer on a substrate, forming a photoresist on the liftoff layer and patterning the photoresist by removing a portion thereof, etching, using a first solvent, the liftoff layer in a region where the photoresist is removed so that a portion of the liftoff layer remains on the substrate, forming an organic light-emitting layer as etch stop layer above the liftoff layer that remains on the substrate and above a region where the photoresist remains on the liftoff layer, and removing, using a second solvent, the liftoff layer under the region where the photoresist remains on the liftoff layer. Fluoropolymer may contain at least one of polytetrafluoroethylene, polychlorotrifluoroethylene, polydichlorodifluoroethylene, a copolymer of chlorotrifluoroethylene and dichlorodifluoroethylene, a copolymer of tetrafluoroethylene and perfluoroalkylvinylether, a copolymer of chlorotrifluoroethylene and perfluoroalkylvinylether, a copolymer of tetrafluoroethylene and perfluoroalkylvinylether, and a copolymer of chlorotrifluoroethylene and perfluoroalkylvinylether. First and second solvents contain fluorine and generally are hydrofluoroethers, such as those of 3M NOVEC® 7100, 7300 and 7500.

Still in a similar manner, US9091913 discloses a method for producing a spatially patterned structure on a substrate, including the steps of:

(1) forming a layer of a material on at least a portion of a substructure of said spatially patterned structure;
(2) forming a barrier layer of a fluorinated material on said layer of material to provide an intermediate structure;
(3) forming a layer of a photoresist on said barrier layer;
(4) exposing said photoresist to spatially patterned radiation;
(5) developing said photoresist to substantially remove one of exposed or unexposed regions of said photoresist to provide a pattern of uncovered regions of barrier material between regions covered by photoresist;
(6) removing portions of said barrier material that are uncovered by said photoresist to provide a pattern of uncovered

regions of said layer of material;
(7) exposing said intermediate structure to at least one of a second material or radiation to cause at least one of a chemical change or a structural change to at least a portion of said intermediate structure; and (8) removing remaining portions of said barrier layer using a fluorinated solvent. In the said method, the fluorinated material barrier layer substantially protects said layer of said material from chemical and structural changes during said forming said layer of said photoresist and said exposing said photoresist. The fluorinated material may be a fluorinated polymer, such as notably materials known under brand names CYTOP® or TEFLON®-AF which are known for including alicylic structure in main chain, or may be fluorinated compounds of formula $C_nF_{(2n+2)}$; while this document acknowledges that the presence of other chemical moieties beside $CF_2$ may be tolerated, it specifically teaches that -COOH groups would greatly alter the solubility property and therefore -COOH compounds (carboxylic acids) may not be suitable. The solvents used for the removal of such fluoropolymer barrier layer encompass perfluorodecaline, perfluoro(1,2- or 1,3-dimethylcyclohexane, perfluorokerosene, perfluoro(methyldecalin), perfluoroheptane mixed isomers, and, more generally, volatile fluorinated solvents. The method of this document can be used for creating diode junctions.

In this area, nonetheless, for a method involving removal of lift-off layer made from a fluorinated polymer to be particularly adapted to be used in an OLED lithographic process, the removal shall comply with certain diverging requirements: it shall maintain substantially un-modified, with no swelling by nor adsorption of stripping solvent by the underlying layer(s), including e.g. electron transporting layers or light emitting layers, and shall provide rapid, effective and exhaustive removal of fluorinated polymer from the same layers, so as not to impair, because of fluorinated residues, the electroluminescence performances of the light emitting layers,.

While certain materials such as the aforementioned CYTOP® or TEFLON®-AF have been tested in this field of use, and removed with fluorosolvents such as hydrofluoroethers, there remains a need in this area for providing an improved method for removing a lift-off/protective layer made from fluorinated polymer from a subtrate.

WO 2016/019273 A1 discloses method of making an OLED device; the method includes providing a first undercut lift-off structure over a device substrate having a first pattern of openings corresponding to the first array of bottom electrodes and removing the first undercut lift-off structure by treatment with a first lift-off agent comprising a fluorinated solvent, and also providing a second undercut lift-off structure over a first intermediate structure having a second pattern of openings and includes removing the second undercut lift-off structure and overlying second organic EL medium layer(s) by treatment with a second lift-off agent comprising a fluorinated solvent to form a second intermediate structure. The lift-off structure includes a fluorinated material base layer and an overlying photoresist layer developed using a fluorinated solvent selected from those that are perfluorinated or highly fluorinated liquids at room temperature, which are immiscible with water and many organic solvents. Among those solvents, hydrofluoroethers (HFEs), including segregated HFEs, are recommended as preferred solvents.

WO 2016/019212 A1 discloses a method of patterning a device using a resist precursor structure having at least two fluoropolymer layers. A first fluoropolymer layer includes a first fluoropolymer material having a fluorine content of at least 50% by weight and is soluble in a first hydrofluoroether solvent or in a first perfluorinated solvent, but less soluble in a second hydrofluoroether solvent relative to both the first hydrofluoroether and the first perfluorinated solvent. The second fluoropolymer layer includes a second fluoropolymer material having a fluorine content less than that of the first fluoropolymer material and is substantially soluble in the first or second hydrofluoroether solvents, but less soluble in the first perfluorinated solvent relative to both the first and second hydrofluoroether solvents.

## Summary of invention

A first object of the present invention is hence a method of at least partially removing a lift-off layer [layer (LO)] made of a composition ($C_{LO}$) comprising at least one fluoropolymer comprising:

- repeating units having an alicyclic structure in main chain of said fluoropolymer and derived from at least one fluoromonomer A, and, optionally,
- repeating unit derived from at least one fluoromonomer B different from fluoromonomer A,

said fluoropolymer:

- possessing an intrinsic viscosity of less than 30 cc/g, when measured at 30°C in perfluorohexane as solvent; and
- comprising an amount of carboxylic end groups of less than 8 mmol/kg; said method comprising:
- providing an assembly comprising a support material having regions covered by a layer (LO);
- contacting said assembly with a stripping solvent mixture comprising:

  a) at least one fluorinated solvent [solvent (F)] having a Hansen solubility parameter $\delta_T$ of less than 15.0 $MPa^{1/2}$;

b) from 10 to 10 000 ppm, based on weight of solvent (F), of at least one polar organic solvent different from solvent (F) [solvent (P)], said solvent (P) possessing a Hansen solubility parameter $\delta_T$ of at least 20.0 $MPa^{1/2}$ and of at most 26.0 $MPa^{1/2}$,

so as to obtain at least partial removal of said layer (LO).

The Applicant has surprisingly found that by carefully (i) selecting a polymer (F) possessing said alicyclic structure in the main chain, fulfilling the above recited requirements of intrinsic viscosity, and content of carboxylic end groups, and (ii) selecting a peculiar stripping solvent mixture, including a fluorinated solvent having low Hansen solubility parameter and a minor amount of another solvent having higher Hansen solubility parameter, it is possible to achieve effective removal of lift-off layer, without detrimentally affecting properties of substrate or of other layers of the assembly.

**Brief description of Figure**

Figure 1 is a graph depicting normalized luminescence as a function of time for a reference OLED device, assembled with no use of lift-off layer, for device (1), manufactured applying a lift-off layer and removing the same according to the invention, and for device (2C) of comparison, not manufactured according to the method of the invention.

**Description of embodiments**

The polymer (F)

As used herein, the expression "fluoromonomer" is to be understood to encompass monomers possessing at least one fluorine atom bound to a carbon atom. The said fluoromonomer may or may not comprise hydrogen atom(s) bound to its carbon atoms. When the fluoropolymer does not comprise any hydrogen atom(s) bound to its carbon atoms, said fluoromonomer will be referred to as a "perfluoromonomer".

As said, polymer (F) comprises repeating units having an alicyclic structure in main chain of said fluoropolymer and derived from at least one fluoromonomer A. The fluoromonomer A of the polymer (F) of the present invention specifically includes two types of fluoromonomers, i.e. fluoromonomers having an alicyclic structure in their monomeric form and fluoromonomers which do not have an alicylic structure in their monomeric form, but which upon cyclopolymerization provide for an alicyclic structure in the resulting repeating unit of polymer (F).

Fluoromonomer A is preferably a perfluoromonomer.

The repeating unit derived from said fluoromonomer A is preferably represented by any one of the following formulae (1) to (3):

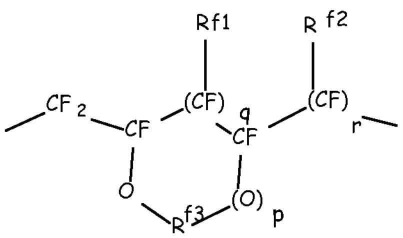
(1)

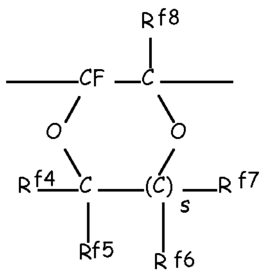
(2)

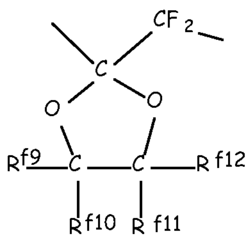
(3)

wherein:

in the formula (1) each of p, q and r which are independent of each other, is 0 or 1, each of $R^{f1}$ and $R^{f2}$ which may be the same or different, is a fluorine atom, a $C_1$-$C_5$ perfluoroalkyl group or a $C_1$-$C_5$ perfluoroalkoxy group, and $R^{f3}$ is a $C_1$-$C_3$ perfluoroalkylene group, which may have a $C_1$-$C_5$ perfluoroalkyl group or a $C_1$-$C_5$ perfluoroalkoxy group, as a substituent;

in the formula (2), s is 0 or 1, each of $R^{f4}$, $R^{f5}$, $R^{f6}$ and $R^{f7}$ which may be the same or different, is a fluorine atom or a $C_1$-$C_5$ perfluoroalkyl group, and $R^{f8}$ is a fluorine atom, a $C_1$-$C_5$ perfluoroalkyl group or a $C_1$-$C_5$ perfluoroalkoxy group, provided that $R^{f4}$ and $R^{f5}$ may be connected to form a spiro ring when s=0; and

in the formula (3), each of $R^{f9}$, $R^{f10}$, $R^{f11}$ and $R^{f12}$ which may be the same or different, is a fluorine atom or a $C_1$-$C_5$ perfluoroalkyl group or a $C_1$-$C_5$ perfluoroalkoxy group.

The structure of the repeating unit of the above formula (1) may be advantageously derived from fluoromonomers which do not have an alicylic structure in their monomeric form, but which upon cyclopolymerization provide for an alicyclic structure in the repeating unit derived therefrom. As said, in formula (1) above, the perfluoroalkylene group represented by $R^{f3}$ may have a $C_1$-$C_5$ perfluoroalkyl group or a $C_1$-$C_5$ perfluoroalkoxy group bonded as a substituent. Further, generally, in the formula (1), when q=o, then r=1 and/or alternatively when q=1, then r=0. Specific examples of repeating units of formula (1) include notably those represented by the following formulae (4) to (19):

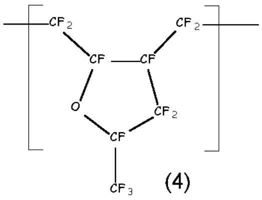
(4)
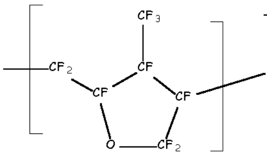
(5)
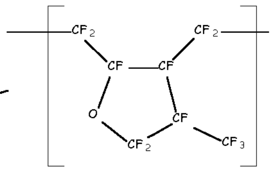
(6)
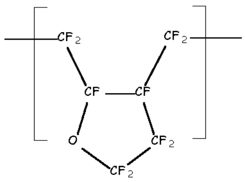
(7)

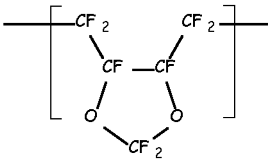
(8)
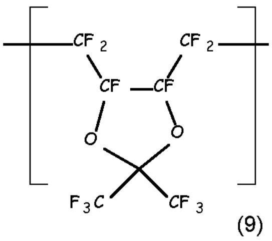
(9)
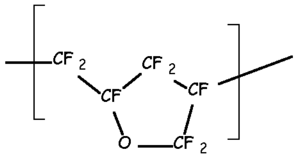
(10)

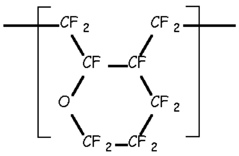
(11)
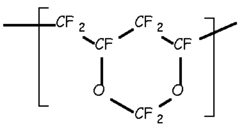
(12)
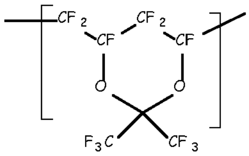
(13)
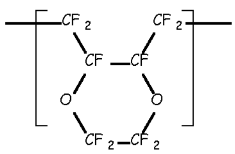
(14)

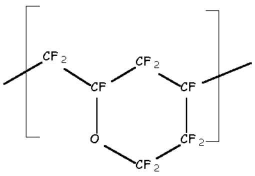
(15)
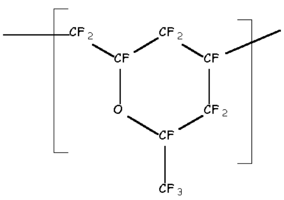
(16)
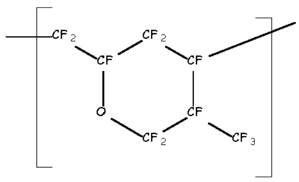
(17)

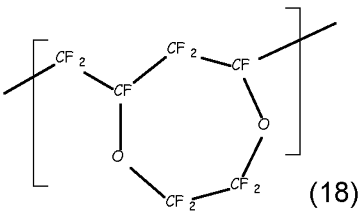
(18)
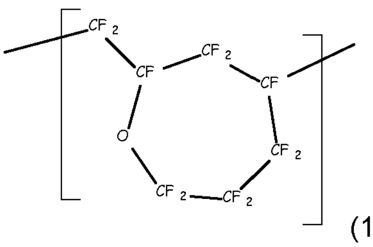
(19)

Among repeating units of the above formula (1), preferred are repeating units of formula (4), as above detailed.

Recurring units of formula (4) are obtained advantageously from radical cyclopolymerization of perfluoro(3-butenyl vinyl ether) of formula (4A):

$CF_2$=CF-O-$CF_2$-$CF_2$-CF=$CF_2$.

Further, the structure of the repeating unit of the above formula (2) may be advantageously derived from a fluoromonomer having an alicyclic structure in its monomeric structure. Further, in a case where in the structure of the repeating unit of the formula (2), when the *spiro* ring formed by $R^{f4}$ and $R^{f5}$ when s=0, is a 4- to 6-membered ring, such a ring may contain an ether oxygen atom as an element constituting the ring, and such a ring may have a perfluoroalkyl group bonded as a substituent.

Specific examples of repeating units of formula (2) include notably those represented by the following formulae (20) to (30):

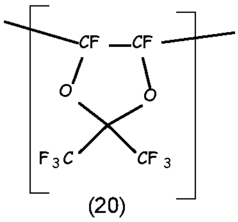
(20)

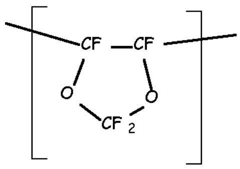
(21)

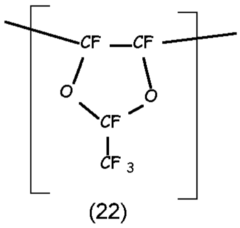
(22)

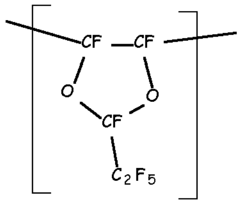
(23)

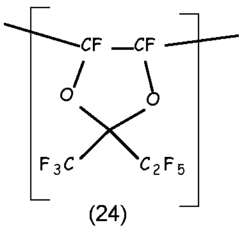
(24)

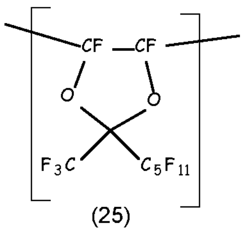
(25)

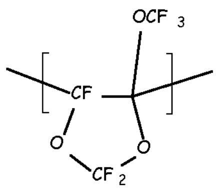
(26)

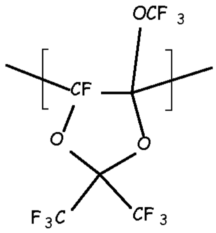
(27)

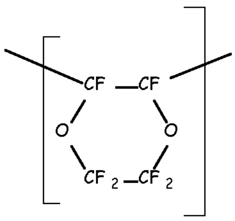
(28)

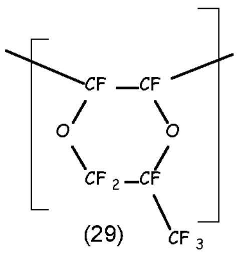
(29)

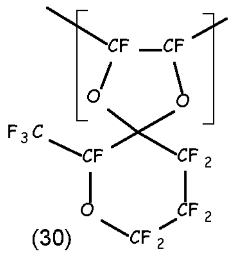
(30)

Among repeating units of the above formula (2), preferred are repeating units of formula (20), (21) and (26), as above detailed. Recurring units of formula (20), (21) and (26) are obtained advantageously from radical polymerization of perfluoro(2,2-dimethyl-1,3-dioxole) of formula (20A), perfluoro(1,3-dioxole) of formula (21A), and 2,2,4-trifluoro-5-trifluoromethoxy-1,3-dioxole of formula (26A), respectively:

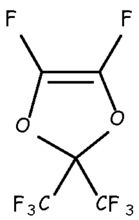
(20A)

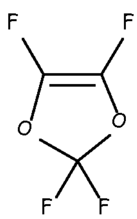
(21A)

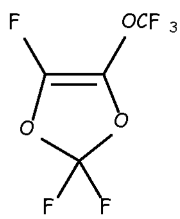
(26A) .

Further, the structure of the repeating unit of the above formula (3) may be advantageously derived from a fluoromonomer having an alicyclic structure in its monomeric structure.

Specific examples of repeating units of formula (3) include notably those represented by the following formulae (31) to (33):

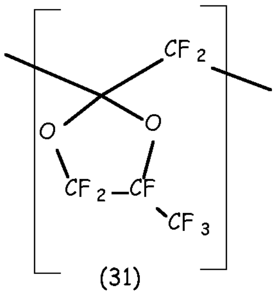
(31)

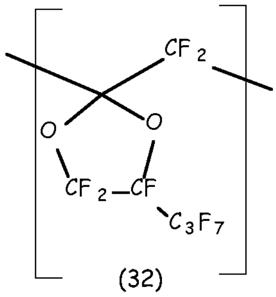
(32)

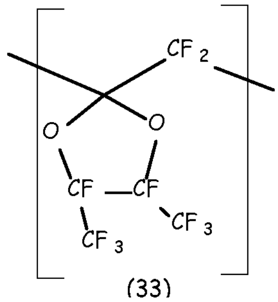
(33)

Among repeating units of the above formula (3), preferred are repeating units of formula (31), as above detailed. Repeating units of formula (31) are derived from perfluoro(2-methylene-4-methyl-1,3-dioxolane) of formula (31A):

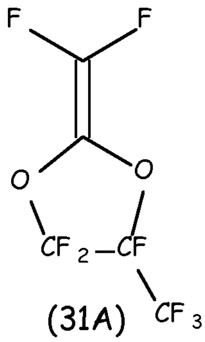
(31A)

.

As said, polymer (F) may comprise repeating unit derived from at least one fluoromonomer B different from fluoromonomer A.

Fluoromonomer B may be selected from the group consisting of:

(a) $C_2$-$C_8$ perfluoroolefins such as tetrafluoroethylene (TFE), hexafluoropropylene (HFP);
(b) hydrogen-containing $C_2$-$C_8$fluoroolefins, such as vinylidene fluoride (VDF), vinyl fluoride, trifluoroethylene (TrFE), hexafluoroisobutylene (HFIB), perfluoroalkyl ethylenes of formula $CH_2$=CH-$R_{f1}$, wherein $R_{f1}$ is a $C_1$-$C_6$ perfluoroalkyl group;
(c) $C_2$-$C_8$ chloro- and/or bromo-containing fluoroolefins such as chlorotrifluoroethylene (CTFE);
(d) perfluoroalkylvinylethers (PAVE) of formula $CF_2$=CFOR$_{f1}$, wherein $R_{f1}$ is a $C_1$-$C_6$ perfluoroalkyl group, such as $CF_3$ (PMVE), $C_2F_5$ or $C_3F_7$;
(e) perfluorooxyalkylvinylethers of formula $CF_2$=CFOX$_0$, wherein $X_0$ is a $C_1$-$C_{12}$ perfluorooxyalkyl group comprising one or more than one ethereal oxygen atom, including notably perfluoromethoxyalkylvinylethers of formula $CF_2$=CFOCF$_2$OR$_{f2}$, with $R_{f2}$ being a $C_1$-$C_3$ perfluoro(oxy)alkyl group, such as -$CF_2CF_3$, -$CF_2CF_2$-O-$CF_3$ and -$CF_3$; and
(f) functional perfluoro(oxy)alkylvinylethers of formula $CF_2$=CFOY$_0$, wherein $Y_0$ is a $C_1$-$C_{12}$ perfluoro(oxy)alkylene group, optionally comprising one or more than one ethereal oxygen atom, which comprises at least one functional group selected from the group consisting of -$SO_2$X, -COX, - $PO_2$X, with X being a halogen or a -OX$_a$ group, with $X_a$ being H, an ammonium group or a metal cation.

Fluoromonomer B is preferably a perfluoromonomer, and is more preferably selected from the group consisting of $C_2$-$C_8$ perfluoroolefins, and most preferably fluoromonomer B is tetrafluoroethylene (TFE).

Polymer (F) may comprise repeating units derived from monomers different from fluoromonomer A and fluoromonomer B; notably, polymer (F) may comprise recurring units derived from fluorine-free monomers, such as alpha-olefins (e.g. ethylene, propylene, butenes, hexenes), vinyl monomers (e.g. optionally substituted styrene-type monomers; (meth)acrylic monomers). Nevertheless, it is generally preferred for polymer (F) to consist essentially of monomers which are perfluorinated, that is to say which do not comprise any C-H moiety. Minor amounts (e.g. less than 1 % moles, preferably less than 0.1 % moles, with respect to overall moles of repeating units) of repeating units derived from hydrogen-containing monomers may be tolerated, without this significantly affecting performances of polymer (F). According to these embodiments, polymer (F) preferably essentially consists of:

- repeating units having an alicyclic structure in main chain of said fluoropolymer and derived from at least one fluoromonomer A which is perfluorinated; and, optionally,
- repeating unit derived from at least one fluoromonomer B different from fluoromonomer A, which is perfluorinated.

Polymer (F) is advantageously an amorphous polymer. The expression "amorphous" is hereby used in connection with polymer (F) for designating polymers which possess a heat of fusion of less than 5 J/g, preferably less than 3 J/g, more preferably less than 2 J/g, when determined according to ASTM D3418.

As said, according to a first variant of the present invention, polymer (F) may be a homopolymer essentially consisting of repeating units having an alicyclic structure in main chain of said fluoropolymer and derived from a fluoromonomer A which is perfluorinated. Homopolymers consisting of repeating units derived from a fluoromonomer A selected from the group consisting of perfluoro(2-methylene-4-methyl-1,3-dioxolane), perfluoro(2,2-dimethyl-1,3-dioxole), perfluoro(1,3-dioxole), 2,2,4-trifluoro-5-trifluoromethoxy-1,3-dioxole and perfluoro(3-butenyl vinyl ether) are exemplary preferred embodiments of polymer (F) according to this variant of the invention.

It is understood that because of their structure, repeating units having an alicyclic structure in main chain of said fluoropolymer and derived from a fluoromonomer A will generally lead to a homopolymer which is substantially amorphous, as above detailed.

According to other variants of the present invention, polymer (F) may comprise repeating units derived from at least one fluoromonomer B; these repeating units may or may not contribute to form crystalline domains in polymer (F).

Nevertheless, in general, when polymer (F) comprises repeating units derived from at least one fluoromonomer B, as detailed above, the respective amount of repeating units derived respectively from fluoromonomer A and fluoromonomer B are adjusted so that polymer (F) is substantially amorphous. According to these embodiments, polymer (F) comprises (and preferably consists essentially of):

- from 20 to 95 % moles, preferably from 30 to 80 % moles, more preferably from 35 to 50 % moles, with respect to the total moles of repeating units of polymer (F), of repeating units having an alicyclic structure in main chain of said fluoropolymer and derived from at least one fluoromonomer A, as above detailed; and
- from 5 to 80 % moles, preferably from 20 to 70 % moles, more preferably from 50 to 65 % moles, with respect to the total moles of repeating units of polymer (F), of repeating units derived from at least one fluoromonomer B different from fluoromonomer A, as above detailed.

The expression "consisting essentially of' when used in connection with polymer (F) and its constituting repeating units is to be understood to mean that defects, end chains, impurities, chains inversions or branchings and the like may be additionally present in the polymer (F) in addition to the recited repeating units, without these components substantially modifying the behaviour and properties of the polymer (F).

According to certain preferred embodiments of this variant, polymer (F) is a copolymer comprising:

- repeating units having an alicyclic structure in main chain of said fluoropolymer and derived from at least one fluoromonomer A which is perfluorinated, as above detailed, and
- repeating unit derived from at least one fluoromonomer B different from fluoromonomer A, which is perfluorinated, as above detailed.

More preferably, polymer (F) is a copolymer comprising:

- repeating units derived from at least one fluoromonomer A selected from the group consisting of perfluoro(2-methylene-4-methyl-1,3-dioxolane), perfluoro(2,2-dimethyl-1,3-dioxole), perfluoro(1,3-dioxole), 2,2,4-trifluoro-5-trifluoromethoxy-1,3-dioxole and perfluoro(3-butenyl vinyl ether); and
- repeating unit derived from tetrafluoroethylene (TFE).

Most preferably, polymer (F) is a copolymer comprising, preferably consisting essentially of:

- repeating units derived from 2,2,4-trifluoro-5-trifluoromethoxy-1,3-dioxole; and
- repeating unit derived from tetrafluoroethylene (TFE).

The intrinsic viscosity of polymer (F) can be determined using the Solomon-Ciuta equation on the basis of dropping time, at 30°C, of a solution obtained by dissolving the polymer (F) in Fluorinert® FC72 (known for being perfluorohexane) at a concentration of 1 g/dl using a Ubbelhode viscosimeter.

As said, polymer (F) possesses an intrinsic viscosity of less than 30 cc/g, preferably less than 25 cc/g, more preferably less than 20 cc/g, when determined in Fluorinert® FC72 (known for being perfluorohexane) as solvent at a

temperature of 30 °C.

While lower boundary for intrinsic viscosity is not particularly limited, it would be preferred for polymer (F) to possess an intrinsic viscosity of at least 5, preferably at least 7, more preferably at least 10 cc/g, when determined in Fluorinert® FC72 (known for being perfluorohexane) as solvent at a temperature of 30 °C.

The expression "amount of carboxylic end groups" is hereby used to encompass the overall amount of carboxylic chain end in polymer (F) which may be present under their acidic form (-COOH), their acyl halide form ($-COX_x$, with $X_x$ being F, Cl or Br, generally $X_x$ being F) and their carboxylate form ($-COOX_b$, with $X_b$ being a (alkyl)ammonium, or a metal cation). Methods for determining amounts of carboxylic end groups in polymer (F) are known; said amount can be determined pursuant to the methodology described in PIANCA, M., et al. End groups in fluoropolymers. Journal of Fluorine Chemistry. 1999, vol.95, p.71-84.

As said, polymer (F) comprises an amount of carboxylic end groups of at most 8.0 mmol/kg, preferably at most 7.5 mmol/kg, more preferably at most 7.0 mml/kg, even more preferably at most 6.5 mmol/kg, still more preferably of at most 6.0 mmol/kg.

Lower amount of carboxylic end groups is not particularly critical; for instance, polymers (F) whereas carboxylic end groups are substantially absent, that it to say that their amount is below the detection limit of the method described above, may be used. According to other embodiments, polymers (F) whereas a minimum amount of carboxylic end groups is present may be used, and may be found advantageous, to the sake of delivering a certain advantageous adhesion to the underlying support layer. According to these embodiments, polymer (F) may possess an amount of carboxylic end groups which is at least detectable, or even of at least 0.5 or even at least 1.0 mmol/kg.

Tuning of viscosity, and of molecular weight and carboxylic end groups concentration may be achieved either during polymerization for manufacturing polymer (F), by acting on relative concentrations of inorganic peroxide initiators leading to the said polar end groups and acting on concentration of growing chains (so further impacting viscosity), chain transfer agents controlling viscosity but also introducing alternative chain terminations, and other polymerization parameters including monomers' concentration, pressure, temperature, etc... Further, posttreatment methods, such as fluorination, depolymerisation, irradiation, and the like, may be used for further increasing or decreasing viscosity and/or modify the nature of end groups.

For the purposes of the present invention, solvent (F) and solvent (P) have been characterized by means of their Hansen total solubility parameter $\delta_T$; according to Hansen's approach, parameter $\delta_T$ is split into three components: polar, dispersion, and hydrogen bonding, wherein the equation 1, here below describes the relationship of the various components to the total solubility parameter $\delta_T$:

$$\delta_T^{\,2} = \delta_D^{\,2} + \delta_P^{\,2} + \delta_H^{\,2} \quad \text{(eq. 1)}$$

Solvents (F) which have been found particularly useful in the practice of the method of the present invention are those which have the following components:

| | |
|---|---|
| dispersion component, $\delta_D$ | from 11.0 to 14.50 |
| polar component, $\delta_P$ | from 0.1 to 5.0 |
| hydrogen bonding component, $\delta_H$ | from 0.0 to 2.0. |

From structural perspective, preferred solvents (F) are hydrofluoroethers (HFEs), i.e. ethers comprising partially fluorinated hydrocarbon structure, comprising both hydrogen and fluorine atoms bound to $sp^3$-hybridized carbons.

Examples of readily available HFEs and isomeric mixtures of HFEs include, but are not limited to, an isomeric mixture of methyl nonafluorobutyl ether and methyl nonafluoroisobutyl ether (notably commercially available as NOVEC® HFE-7100), an isomeric mixture of ethyl nonafluorobutyl ether and ethyl nonafluoroisobutyl ether (notably commercially available as NOVEC® HFE-7200), 3-ethoxy-1, 1,1,2,3,4,4,5,5,6,6,6-dodecafluoro-2-trifluoromethyl-hexane (notably commercially available as NOVEC® HFE-7500), 1-methoxyheptafluoropropane (notably commercially available as NOVEC® HFE-7000), 1,1,1,2,2,3,4,5,5,5-decafluoro-3-methoxy-4-trifluoromethylpentane (notably commercially available as NOVEC® HFE-7300).

Preferred solvents (F) are those possessing a normal boiling point of exceeding 60°C and of at most 130°C; more preferably, normal boiling point of solvent (F) is comprised between 60 and 110°C.

A solvent (F) which has been found particularly effective is 1,1,1,2,2,3,4,5,5,5-decafluoro-3-methoxy-4-trifluoromethylpentane (notably commercially available as NOVEC® HFE-7300).

As per solvents (P), it is preferred for solvent (P) to possess a solubility parameter of at most 25.5 $MPa^{1/2}$. Among solvents (P) whose solubility parameter $\delta_T$ is of at least 20.0 $MPa^{1/2}$ and of at most 25.5 $MPa^{1/2}$ mention may be notably made of cyclopentanol ($\delta_T$ = 25.1 $MPa^{1/2}$), PGME ($\delta_T$ = 21.9 $MPa^{1/2}$), cyclohexanol ($\delta_T$ = 22.4 $MPa^{1/2}$).

Cyclopentanol is particularly preferred.

The amount of solvent (P) is as said of 10 to 10 000 ppm, preferably of 100 to 1500 ppm, based on weight of solvent (F).

Composition ($C_{LO}$) comprises at least one polymer (F), that is to say that it may comprise one or more than one polymer (F). Generally, composition ($C_{LO}$) comprises no other polymer component beyond polymer(s) (F) and may comprise certain amounts of additives, such as viscosity modifiers, stabilizers, anti-oxidants, UV-stabilizers, and the like. It is nevertheless generally understood that the stability of polymer (F) is generally such that use of additives may be avoided. According to preferred embodiments, hence, composition ($C_{LO}$) consists essentially of polymer (F), that is to say that minor amounts (e.g. of less than 1.0 % wt, preferably less than 0.5 % wt, more preferably less than 0.1 % wt, with respect to overall weight of composition ($C_{LO}$) ) of impurities, additives or other ingredients may be tolerated, provided that their presence does not substantially affect the prominent features of layer (LO) of polymer (F).

According to certain embodiments, the method of the present invention is used in a process for producing a patterned structure on a substrate, which is another object of the present invention.

The process of producing a patterned structure on a substrate comprises the steps of:

(1) applying a composition ($C_{LO}$), comprising at least one polymer (F) on at least a portion of the substrate, so as to obtain a layer (LO) composition ($C_{LO}$) comprising polymer (F) onto said substrate;
(2) patterning the said layer (LO) so as to obtain a patterned layer (LO) comprising a pattern of covered and uncovered regions;
(3) at least partially removing uncovered regions of said patterned layer (LO), by contacting with a stripping solvent mixture according to the method of the invention, so as to obtain a patterned structure comprising a pattern of a layer (LO) on said substrate.

The step (1) of applying the composition ($C_{LO}$) may be effected by spreading said composition ($C_{LO}$) onto said substrate according to known coating techniques, including notably as doctor-blade coating, metering rod (or Meyer rod) coating, slot die coating, knife over roll coating, gap coating, spin coating and the like, so as to obtain a wet layer; subsequent at least partial removal of the liquid medium, as above detailed, would advantageously lead to the said lift-off layer onto said substrate. According to these embodiments, polymer (F) may be solubilized or dispersed in a liquid medium prior to step (1), and step (1) may hence comprise a step of removing said liquid medium. According to these embodiments, the liquid medium generally comprises at least one organic solvent. The said organic solvent may be selected from the group consisting of organic solvents containing at least one fluorine atoms, including notably perfluoroalkanes, perfluoroethers, hydrofluoroethers, fluoro-amines, perfluoro-amines, fluoro-cyclic organic compounds or mixtures thereof. HFE, as described above in connection with solvent (F) may be used. To the sake of minimizing the number of different liquid media used in the method, liquid medium may be the same as the stripping solvent mixture. Liquid medium is generally removed and recovered by evaporation; in case liquid medium is the same as the same as the stripping solvent mixture.

Step (2) comprises patterning the said layer (LO) so as to obtain a patterned layer (LO) comprising a pattern of covered and uncovered regions. Methods of achieving said patterning are not particularly limited. According to preferred embodiments, step (2) comprises:

a sub-step (2A) of forming a layer of a photoresist on said layer (LO), so as to obtain a photoresist layer;
a sub-step (2B) of exposing said photoresist layer to patterned radiation, so as to obtain a patterned photoresist layer comprising radiation-modified and non-radiation modified regions; and
a sub-step (2C) of substantially removing either of the said radiation-modified and non-radiation modified regions, so as to obtain a patterned layer (LO) comprising a pattern of photoresist-covered and photoresist-uncovered regions.

The choice of photoresist is not particularly limited. Photoresists well known in the art can be used, including positive and negative photoresists, that is to say photoresists whereas exposure to radiation makes the same more easily removable, e.g. more soluble (so-called "positive" photoresists) and photoresists whereas exposure to radiation makes the same less removable, e.g. less soluble, for instance via crosslinking/polymerisation (so-called "negative" photoresists).

The step (2B) of exposing the photoresist to patterned radiation may be obtained by irradiating the photoresist layer obtained from step (2A) interposing a mask opaque to radiation and possessing a patterned structure between the radiation source and the said photoresist layer.

When a positive photoresist is used, step (2B) may provide for radiation-modified region of the photoresist layer which are chemically modified, e.g. to effect de-polymerization/degradation and hence have advantageously acquired significant solvent-solubility and non-radiation modified regions of the said photoresist layer which have not been affected, and which hence advantageously maintain appreciable solvent-resistance.

When a negative photoresist is used, step (2B) may provide for radiation-modified region of the photoresist layer which are cured and hence have advantageously acquired significant solvent-resistance and non-radiation modified regions of the said photoresist layer which are not cured, and which hence advantageously maintain appreciable solvent solubility.

In sub-step (2C), generally either of said radiation modified regions or said non-radiation modified regions of the photoresist layer are advantageously removed. Removal of said regions may be achieved by standard means; it is nonetheless understood that treatment with an organic solvent will be among preferred means for the removal of either of said radiation modified regions or said non-radiation modified regions. The organic solvent used in this sub-step (2C) will be selected by one of ordinary skills in the art depending on the nature of the photoresist, among those which preferably are not able to attack neither the underlying layer (LO).

Result of sub-step (2C) is hence a patterned layer (LO) comprising a pattern of photoresist-covered and photoresist-uncovered regions, whereas advantageously the photoresist-covered regions are regions of layer (LO) covered by regions of the photoresist layer which have not been removed in sub-step (2C).

In step (3), uncovered regions of said patterned layer (LO) of polymer (F) are at least partially removed, so as to obtain a patterned structure comprising a pattern of layer (LO) on said substrate, according to the method of the present invention.

The process for producing a patterned structure on a substrate of the present invention may comprise additional steps, wherein the patterned structure obtained in Step (3) is used as an intermediate structure for deposing and/or patterning and/or removing additional layers.

Notably, the said process may comprise a step (4) of applying an additional coating layer of a material (M) on the patterned structure comprising a pattern of a layer (LO) on said substrate, so as to obtain a patterned structure comprising a pattern of the layer (LO) coated with material (M); and may comprise an additional subsequent step (5) of removing the said pattern of the layer (LO) coated with material (M) so as to obtain a patterned structure comprising corresponding negative pattern of layer of material (M).

Material (M) may be an organic semiconductor material, an organometallic material, a biological material, a metallic material and the like.

Similarly, the choice of the substrate is not particularly limited, and will depend upon the intended use of the patterned structure. For instance, substrate made of polyimides (PI), polyethyleneterephthalate (PET), polyethylene naphthalate (PEN), polyetherimide (PEI), polyamideimide (PAI), glass, silicon, silicon oxide, transparent mixed oxides such as indium tin oxides (ITO), indium zinc oxide, aluminium-doped zinc oxide (AZO), indium-doped cadmium oxide; aluminium, gallium or indium-doped zinc oxide (AZO, GZA or IZO), formulations containing carbon nanotubes, graphene, silver nanoparticles; inherently conductive polymers such as polyanilines, PEDOT:PSS.

Substrates are generally flattened in shape, and may have the form of sheets or films, including flexible films. Substrates may comprise electrodes or other types of electrical connections, including notably metallic electrodes of Cu, Al, Mo, Ag, Mg or alloys combining more than one of said metallic elements.

The present invention will be now described in more detail with reference to the following examples, whose purpose is merely illustrative and not limitative of the scope of the invention.

EXAMPLES

Raw materials

As fluoropolymers, use has been made of several different amorphous perfluorocopolymers consisting essentially of repeating units derived from 2,2,4-trifluoro-5-trifluoromethoxy-1,3-dioxole; and repeating unit derived from tetrafluoroethylene (TFE); more particularly

(FC-1): Fluoropolymer (FC-1) is an amorphous perfluoropolymer possessing an intrinsic viscosity of 38 cc/g and a concentration of carboxylic end groups of 9 mmol/kg;
(FC-2): Fluoropolymer (FC-2) is an amorphous perfluoropolymer possessing an intrinsic viscosity of 14 cc/g and a concentration of carboxylic end groups of 20 mmol/kg;
(FC-3): Fluoropolymer (FC-3) is an amorphous perfluoropolymer possessing an intrinsic viscosity of 33 cc/g and a concentration of carboxylic end groups of below detection limit of used technique;
(F-1): Fluoropolymer (F-1) is an amorphous perfluoropolymer possessing an intrinsic viscosity of 12 cc/g and a concentration of carboxylic end groups of below detection limit of used technique.
(FC-1), (FC-2) and (FC-3) have been used in comparative examples, while (F-1) is the polymer (F) employed in the inventive examples.

**Determination of intrinsic viscosity of polymer (F)**

Intrinsic viscosity (η) [dl/g] was determined using the Solomon-Ciuta equation (reproduced below), measuring dropping time, at 30°C, of a solution obtained by dissolving the polymer (F) in FLUORINERT® FC72 (perfluorohexane) at a concentration of 1 g/dl using a Ubbelhode viscosimeter:

$$[\eta] = \frac{\left[2\left(\eta_{sp} - \ln(\eta_r)\right)\right]^{1/2}}{c} \text{ (Solomon-Ciuta equation)}$$

where c is polymer concentration [g/dl], $\eta_r$ is the relative viscosity, i.e. the ratio between the dropping time of sample solution and the dropping time of solvent, $\eta_{sp}$ is the specific viscosity, i.e. $\eta_r$ -1.

**Determination of carboxylic end groups of polymer (F)**

Amount of carboxylic end groups were determined according to the method described in PIANCA, M., et al. End groups in fluoropolymers. Journal of Fluorine Chemistry. 1999, vol.95, p.71-84. Concentration of relevant chain ends are expressed as mmoles of groups per kg of polymer (F) and encompasses carboxylic end groups in their acidic form (-COOH), acyl halide form (-COF) and salified form ($-COOX_b$, with $X_b$ being (alkyl)amonium or metal cation). Detection limit of the determination of carboxylic end groups is 0.1 mmol/Kg.

**Determination of the thickness of layers on the substrate**

The thickness of layers deposed onto a substrate was determined by using a Filmetrics F50 Automated Film Thickness Mapping. The complex refractive index values of polymer (F) used for calculating the thickness from the reflectance spectra were $n_{489\ nm}$= 1.331; $k_{489\ nm}$ = 0 $n_{589\ nm}$= 1.329; $k_{589\ nm}$ = 0; $n_{656\ nm}$= 1.328; $k_{656\ nm}$ = 0.

**Preparation of stripper solvent mixture [stripper (SM-1), herein after]**

10g of Cyclopentanol (purchased from Sigma-Alrich) was added with 1990 g of NOVEC® 7300 (purchased from 3M) in a 2L plastic bottle. The plastic bottle was shaken during 1 hour, so obtaining a blend of cyclopentanol and NOVEC® 7300 with a cyclopentanol concentration of 0.5 wt.%.

**Embodiments 1 to 3**

A layer of 20 nm of LG201 material (purchased from LG chemical, acting as ETL{electron transfer layer}) was deposited on 1 inch wafer by using thermal evaporating method (LESKER Co.,LTD., KJLL Spectros Deposition system.)

On the so prepared ETL-comprising wafer substrate, a solution of polymer was coated by spin coating method in the conditions below detailed: Spin coater: SUSS Mircrotec Delta6RC, at 1600rpm, for 50 s.

The coated ETL-containing wafer substrate was baked on a hotplate at 100°C for 10 min, so as to form a lift-off layer of polymer (F-1) or of comparative polymers (FC-1) to (FC-3), having a thickness of about 1 μm. Lift-off layer was removed by using stripper solvent mixtures as detailed in the examples below, by dipping into a bath of stripping medium, followed by drying.

**Determination of F-residues on LG201(ETL) layer after stripping of lift-off layer**

TOF-SIMs analysis, using TOFSIMS 5 apparatus from ionTOF company was used to determine F-residues, in the following conditions: 60Kev, current:0.38pA, Area 500 × 500$\mu m^2$. The intensity of the peaks detected at m/z = 19 (F- ions); m/z = 31 (CF- ions) and m/z = 38 ($F_2$- ions) has been normalized to the intensity of the same peaks detected from the LG201 neat surface.

Results are summarized in the table below, whereas:

- Ex. 1C (of comparison) provides for measurements of F-residues after a) formation of a layer (OL) of polymer (FC-1) and b) removal of the same by dipping in neat Novec® 7300;
- Ex. 2C (of comparison) provides for measurements of F-residues after a) formation of a layer (OL) of polymer (FC-1) and b) removal of the same using stripper (SM-1);
- Ex. 3C: (of comparison) provides for measurements of F-residues after a) formation of a layer (OL) of polymer (FC-2) and b) removal of the same using neat NOVEC® 7300;
- Ex. 4C (of comparison): provides for measurements of F-residues after a) formation of a layer (OL) of polymer (FC-2) and b) removal of the same using stripper (SM-1);

- Ex. 5 (according to the invention): provides for measurements of F-residues after a) formation of a layer (OL) of polymer (F) and b) removal of the same using stripper (SM-1);
- Ex. 6C (of comparison): provides for measurements of F-residues after a) formation of a layer (OL) of polymer (FC-3) and b) removal of the same using stripper (SM-1).

| Table 1 | Peak area | | |
|---|---|---|---|
| | F- | CF- | $F_2^-$ |
| Ref.(LG201 layer) | 1 | 1 | 1 |
| Ex. 1C | 345.75 | 333.43 | 2982.92 |
| Ex. 2C | 179.97 | 149.75 | 685.14 |
| Ex. 3C | 339.28 | 313.84 | 2601.51 |
| **Ex. 4C** | **112.53** | **86.4** | **131.2** |
| Ex. 5 | 2.18 | 1.81 | 1.89 |
| Ex. 6C | 18.87 | 15.11 | 20.26 |

Table above clearly demonstrate that best performance in terms of effective removal of layer (OF) is obtained when combining the choice of the polymer (F) with the stripper solvent mixture, according to the method of the present invention.

**Manufacture and performance of OLED devices**

OLED device having the structure described above were manufactured: ITO substrate/HATCN(5nm)/HT011(50nm)/HATCN(5nm)/HT211(140nm)/NS60 :H111:GD270(40nm)[43.5:43.5:13]/LG201 (30nm) 4 layer (LO) 4 removal with stripper/Liq(1 nm)/Al(100nm).

The following raw materials were used:

*HIL layer*: HATCN(1,4,5,8,9,11-Hexaazatriphenylenehexacarbonitrile), *HT011* (N4,N4'Di(naphthalen-1-yl)-N4,N4'-diphenylbiphenyl-4,4'-diamine) *HTL layer*: HT211(N-[1,1'-Diphenyl]-4-yl-9,9-dimethyl-N-[4-(9-phenyl-9H-carbazol-3-yl)phenyl]-9H-fluoren-2-amine)
*EML layer*: NS60(Trade name from Nippon Steel Chemical Co., Ltd.), *H111*(4-[3-(2-triphenylenyl)phenyl]-Dibenzothiophene),
*GD270* (Trade name from P&H Tech.) *ETL layer*: LG201(Trade name from LG Chemical Co.,Ltd.) *EIL layer*: Liq(8-Quinolinolato lithium) *Cathode electrode*: Al (Kojundo co., Ltd. from Japan.)

The devices were prepared according to the below detailed procedure:

1$^{st}$ deposition (HIL - ETL)

1) ITO substrate was cleaned with ultra-sonic process using deionized water for 10 min and then isopropanol for 10 min.
2) Surface of the ITO substrate was treated with oxygen plasma (Condition: (120W, Ar 4L/min, $O_2$ 12mL/min, Levi system co.,LTD from Korea)
3) The plasma-treated ITO substrate was introduced into a vacuum chamber for OLED material deposition.
4) OLED material was deposited on the substrate under high vacuum (less than $10^{-7}$ torr vacuum condition).

I. Forming layer (LO) on ETL

1) The ITO substrate having ETL layer was recovered from the vacuum chamber and moved into a glove box where the ITO substrate was packed to prevent exposure to air.
2) Polymer (F-1) and/or (FC-1) to (FC-3) were coated on surface of ETL at fixed spin coating condition. (Spin coater: SUSS Mircrotec Delta6RC, at 1600rpm, 50s.)

3) The sample substrate was dried on hotplate at 100°C for 10 min.

II. Stripping layer (LO)

1) The sample substrate was dipped in a stripper bath during 10 minutes for removal of layer (LO) from surface of ETL.
2) The sample substrate was dried on hot plate at 100° for 10 min.

III. 2nd deposition (EIL ~ Al)

1) The sample substrate was packed to prevent exposure to air and taken out from the glove box.
2) The sample substrate was introduced into vacuum chamber.
3) OLED material was deposited on the sample substrate under high vacuum (less than 10-7 torr vacuum condition).
4) The sample substrate was encapsulated in glove box after Al deposition, so as to obtain a device.

IV. Evaluation of device performances

1) IVL device characteristics was measured with radio spectrometer. EQE (in %) and voltage (V) @ 10mA/$cm^2$ was determined (CS2000 Konica-Minolta from Japan).
2) Lifetime of device was measured with OLED lifetime system under constant current density (BO TEST Co.LTD-Poland).

Results are summarized in Table 2 below:

| Table 2 | | Ref. | Device 1 | Device 2C | Device 3C | Device 4C |
|---|---|---|---|---|---|---|
| Lift off layer | | - | Polymer (F-1) | Polyme r (FC-1) | Polymer (FC-1) | Polymer (FC-2) |
| Stripper | stripper (SM-1) | n.a. | yes | no | yes | yes |
| | Novec® 7300 | n.a. | no | yes | no | no |
| Device performances | Operating voltage (V) | 10.50 | 10.61 | 2.31 | 9.41 | 9.50 |
| | EQE | 4.38 | 4.34 | 6.88 | 4.91 | 4.89 |

Data above summarized well demonstrate that performances of device (1) are substantially identical to those observed with reference OLED device of same constituting structure, but where no lift-off layer was formed and subsequently removed.

Luminesce life-time of reference OLED device, device (1) and device (2C) of comparison is sketched in Figure 1; device (1), which has been manufactured using notably the method of the present invention, possesses luminescence time-profile substantially undistinguishable from luminescence time-profile of reference OLED device, while comparative device (2C) displays a significant decay in luminescence.

## Claims

**1.** A method of at least partially removing a lift-off layer "layer LO" made of a composition "$C_{LO}$" comprising at least one fluoropolymer comprising:

- repeating units having an alicyclic structure in main chain of said fluoropolymer and derived from at least one fluoromonomer A, and, optionally,
- repeating unit derived from at least one fluoromonomer B different from fluoromonomer A,

said fluoropolymer:

- possessing an intrinsic viscosity of less than 30 $cm^3/g$ (cc/g) ee/g, when measured at 30°C in perfluorohexane as solvent; and
- comprising an amount of carboxylic end groups of less than 8 mmol/kg "polymer F";

said method comprising:

- providing an assembly comprising a support material having regions covered by a layer LO
- contacting said assembly with a stripping solvent mixture comprising:

a) at least one fluorinated solvent "solvent F" having a Hansen solubility parameter $\delta_T$ of less than 15.0 $MPa^{1/2}$;
b) from 10 to 10 000 ppm, based on weight of solvent F, of at least one polar organic solvent P different from solvent F, said solvent P possessing a Hansen solubility parameter $\delta_T$ of at least 20.0 $MPa^{1/2}$ and of at most 26.0 $MPa^{1/2}$, so as to obtain at least partial removal of said layer LO.

**2.** The method of Claim 1, wherein fluoromonomer A is selected from the group consisting of fluoromonomers having an alicyclic structure in their monomeric form and fluoromonomers which do not have an alicylic structure in their monomeric form, but which upon cyclopolymerization provide for an alicyclic structure in the resulting repeating unit of polymer F, tFt, and wherein fluoromonomer A is a perfluoromonomer.

**3.** The method of Claim 2, wherein the repeating unit derived from said fluoromonomer A is preferably represented by any one of the following formulae 1 to 3:

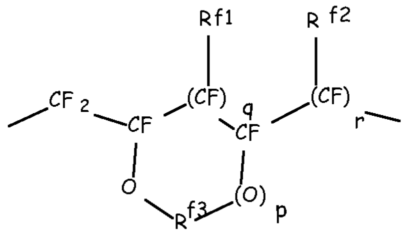
(1)

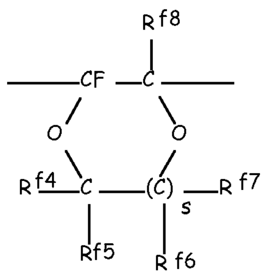
(2)

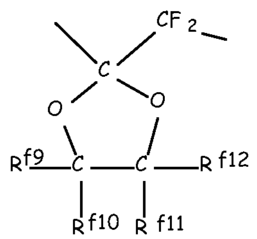
(3)

wherein:

in the formula 1 each of p, q and r which are independent of each other,
is 0 or 1, each of $R^{f1}$ and $R^{f2}$ which may be the same or different, is a fluorine atom, a $C_1$-$C_5$ perfluoroalkyl group or a $C_1$-$C_5$ perfluoroalkoxy group, and $R^{f3}$ is a $C_1$-$C_3$ perfluoroalkylene group, which may have a $C_1$-$C_5$ perfluoroalkyl group or a $C_1$-$C_5$ perfluoroalkoxy group, as a substituent;
in the formula 2, s is 0 or 1, each of $R^{f4}$, $R^{f5}$, $R^{f6}$ and $R^{f7}$ which may be the same or different, is a fluorine atom or a $C_1$-$C_5$ perfluoroalkyl group, and
$R^{f8}$ is a fluorine atom, a $C_1$-$C_5$ perfluoroalkyl group or a $C_1$-$C_5$ perfluoroalkoxy group, provided that $R^{f4}$ and $R^{f5}$ may be connected to form a spiro ring when s=0; and
in the formula (3), each of $R^{f9}$, $R^{f10}$, $R^{f11}$ and $R^{f12}$ which may be the same or different, is a fluorine atom or a $C_1$-$C_5$ perfluoroalkyl group or a $C_{1-}C_5$ perfluoroalkoxy group.

**4.** The method of Claim 3, wherein the repeating unit derived from said fluoromonomer A complies with formula 1, and is selected from the group consisting of those represented by the following formulae 4 to 19:

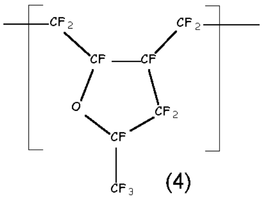
(4)

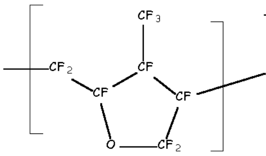
(5)

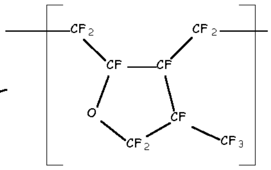
(6)

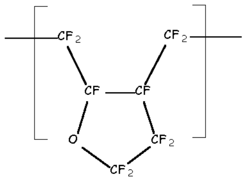
(7)

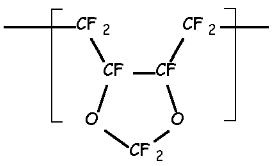
(8)

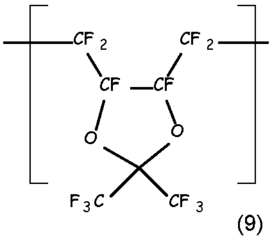
(9)

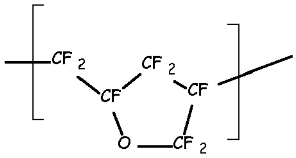
(10)

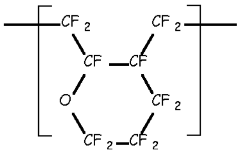
(11)

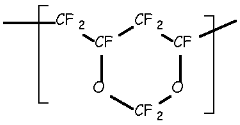
(12)

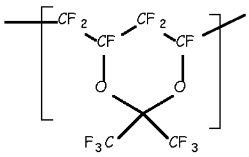
(13)

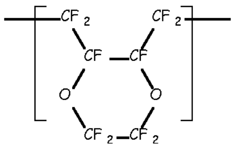
(14)

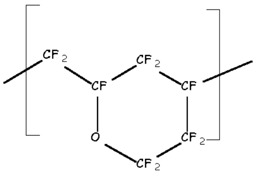
(15)

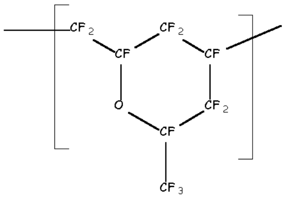
(16)

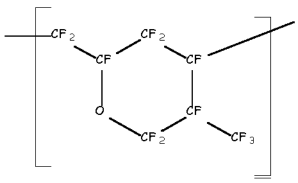
(17)

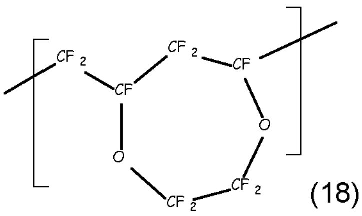
(18)

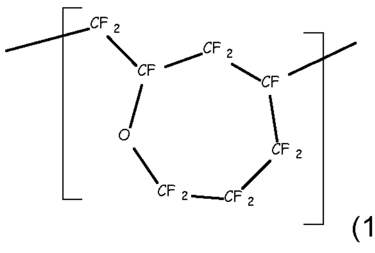
(19)

**5.** The method of Claim 3, wherein the repeating unit derived from said fluoromonomer A complies with formula 2, and is selected from the group consisting of those represented by the following formulae 20 to 30:

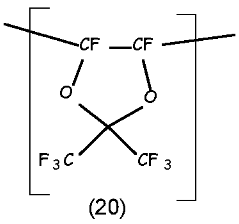
(20)

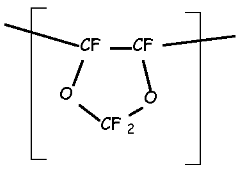
(21)

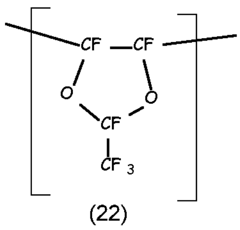
(22)

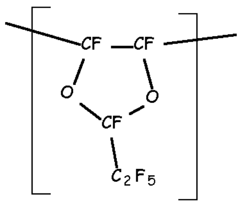
(23)

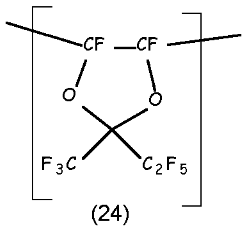
(24)

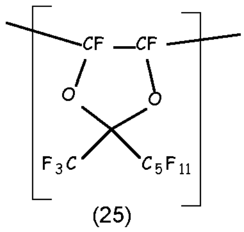
(25)

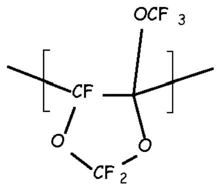
(26)

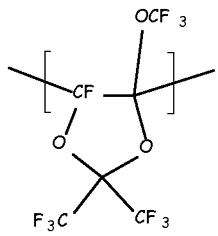
(27)

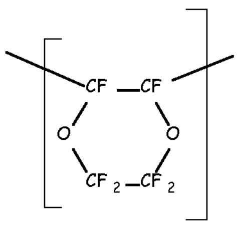
(28)

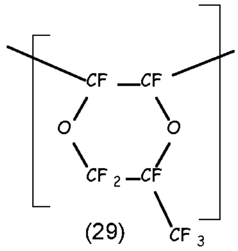
(29)

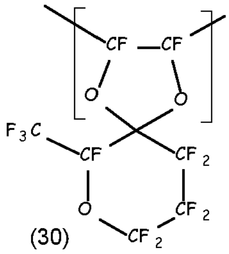
(30)

6. The method of Claim 3, wherein the repeating unit derived from said fluoromonomer A complies with formula 3, and is selected from the group consisting of those represented by the following formulae 31 to 33:

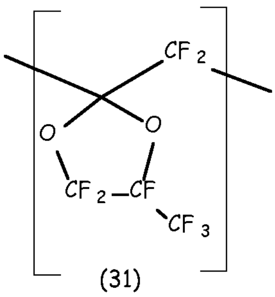
(31)

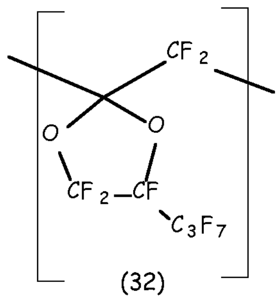
(32)

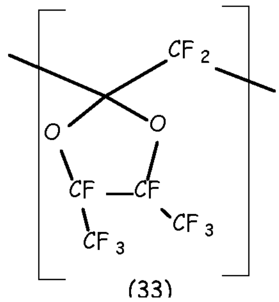
(33)

7. The method according to anyone of the preceding claims, wherein polymer F comprises repeating unit derived from at least one fluoromonomer B different from fluoromonomer A, wherein fluoromonomer B is selected from the group consisting of:

(a) $C_2$-$C_8$ perfluoroolefins such as tetrafluoroethylene "TFE" hexafluoropropylene "HFP";
(b) hydrogen-containing $C_2$-$C_8$fluoroolefins, such as vinylidene fluoride "VDF", vinyl fluoride, trifluoroethylene "TrFE", hexafluoroisobutylene "HFIB", perfluoroalkyl ethylenes of formula $CH_2$=CH-$R_{f1}$, wherein $R_{f1}$ is a $C_1$-$C_6$ perfluoroalkyl group;
(c) $C_2$-$C_8$ chloro- and/or bromo-containing fluoroolefins such as chlorotrifluoroethylene "CTFE";
(d) perfluoroalkylvinylethers "PAVE" of formula $CF_2$=$CFOR_{f1}$, wherein $R_{f1}$ is a $C_1$-$C_6$ perfluoroalkyl group, such as $CF_3$ "PMVE", $C_2F_5$ or $C_3F_7$;
(e) perfluorooxyalkylvinylethers of formula $CF_2$=$CFOX_0$, wherein $X_0$ is a $C_1$-$C_{12}$ perfluorooxyalkyl group comprising one or more than one ethereal oxygen atom, including notably perfluoromethoxyalkylvinylethers of formula $CF_2$=$CFOCF_2OR_{f2}$, with $R_{f2}$ being a $C_1$-$C_3$ perfluoro(oxy)alkyl group, such as - $CF_2CF_3$, -$CF_2CF_2$-O-$CF_3$ and -$CF_3$; and
(f) functional perfluoro(oxy)alkylvinylethers of formula $CF_2$=$CFOY_0$, wherein $Y_0$ is a $C_1$-$C_{12}$ perfluoro(oxy)alkylene group, optionally comprising one or more than one ethereal oxygen atom, which comprises at least one functional group selected from the group consisting of -$SO_2$X, -COX, -$PO_2$X, with X being a halogen or a -$OX_a$ group, with $X_a$ being H, an ammonium group or a metal cation.

8. The method according to claim 7, wherein said polymer F comprises:

- from 20 to 95 % moles, preferably from 30 to 80 % moles, more preferably from 35 to 50 % moles, with respect to the total moles of repeating units of polymer (F), of repeating units having an alicyclic structure in main chain

of said fluoropolymer and derived from at least one fluoromonomer A; and
- from 5 to 80 % moles, preferably from 20 to 70 % moles, more preferably from 50 to 65 % moles, with respect to the total moles of repeating units of polymer F, of repeating units derived from at least one fluoromonomer B different from fluoromonomer A; and wherein preferably polymer F is a copolymer comprising:

- repeating units having an alicyclic structure in main chain of said fluoropolymer and derived from at least one fluoromonomer A which is perfluorinated, and
- repeating unit derived from at least one fluoromonomer B different from fluoromonomer A, which is perfluorinated.

**9.** The method according to Claim 8, wherein polymer F fFt is a copolymer comprising:

- repeating units derived from at least one fluoromonomer A selected from the group consisting of perfluoro(2-methylene-4-methyl-1,3-dioxolane), perfluoro(2,2-dimethyl-1,3-dioxole), perfluoro(1,3-dioxole), 2,2,4-trifluoro-5-trifluoromethoxy-1,3-dioxole and perfluoro(3-butenyl vinyl ether); and
- repeating unit derived from tetrafluoroethylene "TFE", and wherein polymer F is preferably a copolymer, comprising :

- repeating units derived from 2,2,4-trifluoro-5-trifluoromethoxy-1,3-dioxole; and
- repeating unit derived from tetrafluoroethylene "TFE",

**10.** The method according to anyone of the preceding claims, wherein said polymer F:

- comprises an amount of carboxylic end groups of at most 7.5 mmol/kg, more preferably at most 7.0 mml/kg, even more preferably at most 6.5 mmol/kg, still more preferably of at most 6.0 mmol/kg, and/or wherein the amount of carboxylic end groups is not detectable or is of at least 0.5 or even at least 1.0 mmol/kg; and/or
- possesses an intrinsic viscosity of less than 25 $cm^3/g$ (cc/g), more preferably of less than 20 $cm^3/g$ (cc/g) and/or of at least 5 $cm^3/g$ (cc/g), preferably at least 7 $cm^3/g$ (cc/g), more preferably at least 10 $cm^3/g$ (cc/g).

**11.** The method according to anyone of the preceding claims, wherein solvent (F) is selected from the group consisting of those possessing the following solubility parameter components:

dispersion component, $\delta_D$ from 11.0 to 14.50
polar component, $\delta_P$ from 0.1 to 5.0
hydrogen bonding component, $\delta_H$ from 0.0 to 2.0.

**12.** The method according to Claim 11, wherein solvent F tFt is selected from the group consisting from hydrofluoroethers "HFEs" which are ethers comprising partially fluorinated hydrocarbon structure, comprising both hydrogen and fluorine atoms bound to $sp^3$-hybridized carbons, and is preferably selected from the group consisting of:

- an isomeric mixture of methyl nonafluorobutyl ether and methyl nonafluoroisobutyl ether;
- an isomeric mixture of ethyl nonafluorobutyl ether and ethyl nonafluoroisobutyl ether;
- 3-ethoxy-1,1,1,2,3,4,4,5,5,6,6,6-dodecafluoro-2-trifluoromethyl-hexane;
- 1-methoxyheptafluoropropane; and
- 1,1,1,2,2,3,4,5,5,5-decafluoro-3-methoxy-4-trifluoromethylpentane; and

wherein solvent F fFt is most preferably 1,1,1,2,2,3,4,5,5,5-decafluoro-3-methoxy-4-trifluoromethylpentane.

**13.** The method according to anyone of the preceding claims, wherein solvent P tFt is selected from solvents whose solubility parameter $\delta_T$ is of at least 20.0 $MPa^{1/2}$ and of at most 25.5 $MPa^{1/2}$ and is preferably selected from the group consisting of cyclopentanol $\delta_T$ = 25.1 $MPa^{1/2}$, PGME $\delta_T$ = 21.9 $MPa^{1/2}$, and cyclohexanol $\delta T$ = 22.4 $MPa^{1/2}$ and wherein most preferably solvent is cyclopentanol; and/or
wherein the amount of solvent P tFt is of 100 to 1500 ppm, based on the weight of solvent F.

**14.** A process for producing a patterned structure on a substrate,
wherein the process comprises the steps of:

(1) applying a composition "$C_{Lo}$" comprising at least one fluoropolymer comprising:

- repeating units having an alicyclic structure in main chain of said fluoropolymer and derived from at least one fluoromonomer A, and, optionally,
- repeating unit derived from at least one fluoromonomer B different from fluoromonomer A,

said fluoropolymer:

- possessing an intrinsic viscosity of less than 30 cc/g, when measured at 30°C in perfluorohexane as solvent; and
- comprising an amount of carboxylic end groups "polymer F" of less than 8 mmol/kg on at least a portion of the substrate, so as to obtain a layer LO composition "$C_{LO}$" comprising polymer F onto said substrate;

(2) patterning the said layer LO so as to obtain a patterned layer LO comprising a pattern of covered and uncovered regions;
(3) at least partially removing uncovered regions of said patterned layer LO, by contacting with a stripping solvent mixture according to the method of anyone of the preceding Claims, so as to obtain a patterned structure comprising a pattern of a layer LO (LO) on said substrate.

**15.** The process of Claim 14, wherein:

- Step (2) comprises:

a sub-step (2A) of forming a layer of a photoresist on said layer LO, so as to obtain a photoresist layer;
a sub-step (2B) of exposing said photoresist layer to patterned radiation, so as to obtain a patterned photoresist layer comprising radiation-modified and non-radiation modified regions; and
a sub-step (2C) of substantially removing either of the said radiation-modified and non-radiation modified regions, so as to obtain a patterned layer LO comprising a pattern of photoresist-covered and photoresist-uncovered regions; and/or

- the process comprises additional Step (4) of applying an additional coating layer of a material (M) on the patterned structure comprising a pattern of a layer LO on said substrate, so as to obtain a patterned structure comprising a pattern of the layer LO coated with material (M); and may comprise an additional subsequent Step (5) of removing the said pattern of the layer LO coated with material (M) so as to obtain a patterned structure comprising corresponding negative pattern of layer of material (M), wherein material (M) may be an organic semiconductor material, an organimetallic material, a biological material, and a metallic material; and/ or wherein substrate may be made of polyimides "PI", polyethyleneterephthalate "PET", polyethylene naphthalate "PEN", polyetherimide "PEI", polyamideimide "PAI", glass, silicon, silicon oxide, transparent mixed oxides such as indium tin oxides "ITO", indium zinc oxide, aluminium-doped zinc oxide "AZO", indium- doped cadmium oxide; aluminium, gallium or indium-doped zinc oxide "AZO, GZA or IZO", formulations containing carbon nanotubes, graphene, silver nanoparticles; inherently conductive polymers such as polyanilines, poly(3,4-ethylenedioxythiophene) polystyrene sulfonate "PEDOT:PSS".

## Patentansprüche

**1.** Verfahren zum wenigstens teilweisen Entfernen einer abhebbaren Schicht "Schicht LO", die aus einer Zusammensetzung "$C_{LO}$" hergestellt ist, die wenigstens ein Fluorpolymer umfasst, das umfasst:

- Wiederholungseinheiten, die eine alicyclische Struktur in der Hauptkette des Fluorpolymers aufweisen und von wenigstens einem Fluormonomer A abgeleitet sind, und gegebenenfalls
- Wiederholungseinheiten, die von wenigstens einem Fluormonomer B, das von Fluormonomer A verschieden ist, abgeleitet sind,

wobei das Fluorpolymer:

- eine intrinsische Viskosität von weniger als 30 $cm^3/g$ (cc/g), wenn gemessen bei 30 °C in Perfluorhexan als Lösungsmittel, aufweist; und
- eine Menge an Carboxyl-Endgruppen von weniger als 8 mmol/kg umfasst, "Polymer F";

wobei das Verfahren umfasst:

- Bereitstellen einer Baugruppe, die ein Trägermaterial mit Bereichen, die von einer Schicht LO bedeckt sind, umfasst;
- Inkontaktbringen der Baugruppe mit einem Ablöse-Lösungsmittelgemisch, das umfasst:

  a) wenigstens ein fluoriertes Lösungsmittel "Lösungsmittel F" mit einem Hansen-Löslichkeitsparameter $\delta_T$ von kleiner als 15,0 $MPa^{1/2}$;
  b) von 10 bis 10.000 ppm, bezogen auf das Gewicht des Lösungsmittels F, an wenigstens einem polaren organischen Lösungsmittel P, das von dem Lösungsmittel F verschieden ist, wobei das Lösungsmittel P einen Hansen-Löslichkeitsparameter $\delta_T$ von wenigstens 20,0 $MPa^{1/2}$ und höchstens 26,0 $MPa^{1/2}$ aufweist,

um wenigstens teilweises Entfernen der Schicht LO zu erzielen.

**2.** Verfahren gemäß Anspruch 1, wobei das Fluormonomer A ausgewählt ist aus der Gruppe bestehend aus Fluormonomeren mit einer alicyclischen Struktur in ihrer monomeren Form und Fluormonomeren, die keine alicyclische Struktur in ihrer monomeren Form aufweisen, die aber bei Copolymerisation eine alicyclische Struktur in der erhaltenen Wiederholungseinheit des Polymers F ergeben, und wobei das Fluormonomer A ein Perfluormonomer ist.

**3.** Verfahren gemäß Anspruch 2, wobei die von dem Fluormonomer A abgeleitete Wiederholungseinheit vorzugsweise von einer der folgenden Formeln 1 bis 3 dargestellt wird:

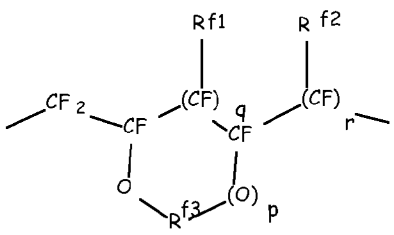
(1)

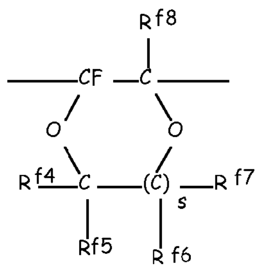
(2)

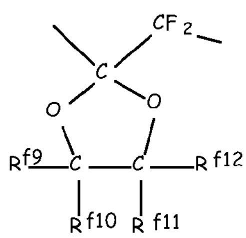
(3)

wobei:

in der Formel 1 jedes von p, q und r, die unabhängig voneinander sind, 0 oder 1 ist, jedes von $R^{f1}$ und $R^{f2}$, die gleich oder verschieden sein können, ein Fluoratom, eine $C_1$-$C_5$-Perfluoralkylgruppe oder eine $C_1$-$C_5$-Perfluoralkoxygruppe ist, und $R^{f3}$ eine $C_1$-$C_3$-Perfluoralkylengruppe ist, die eine $C_1$-$C_5$-Perfluoralkylgruppe oder eine $C_1$-$C_5$-Perfluoralkoxygruppe als Substituent aufweisen kann;
in der Formel 2 s 0 oder 1 ist, jedes von $R^{f4}$, $R^{f5}$, $R^{f6}$ und $R^{f7}$, die gleich oder verschieden sein können, ein Fluoratom oder eine $C_1$-$C_5$-Perfluoralkylgruppe ist, und $R^{f8}$ ein Fluoratom, eine $C_1$-$C_5$-Perfluoralkylgruppe oder eine $C_1$-$C_5$-Perfluoralkoxygruppe ist, mit der Maßgabe, dass $R^{f4}$ und $R^{f5}$ verbunden sein können, um einen Spiroring zu bilden, wenn s = 0; und
in der Formel (3) jedes von $R^{f9}$, $R^{f10}$, $R^{f11}$ und $R^{f12}$, die gleich oder verschieden sein können, ein Fluoratom oder eine $C_1$-$C_5$-Perfluoralkylgruppe oder eine $C_1$-$C_5$-Perfluoralkoxygruppe ist.

**4.** Verfahren gemäß Anspruch 3, wobei die von dem Fluormonomer A abgeleitete Wiederholungseinheit Formel 1 entspricht und ausgewählt ist aus der Gruppe bestehend aus jenen, die von den folgenden Formeln 4 bis 19 dargestellt werden:

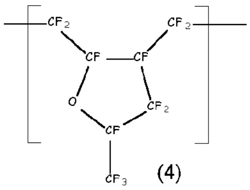 (4)
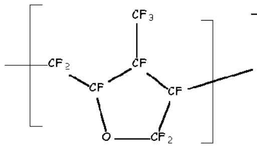 (5)
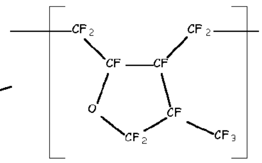 (6)
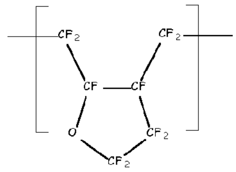 (7)

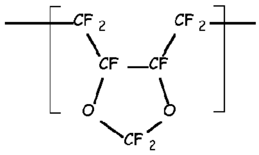 (8)
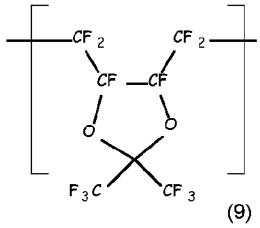 (9)
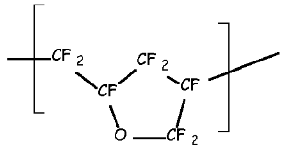 (10)

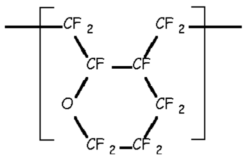 (11)
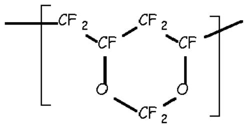 (12)
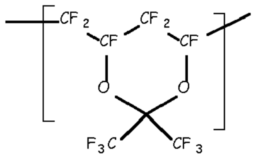 (13)
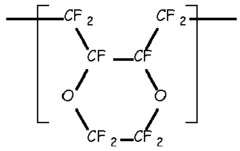 (14)

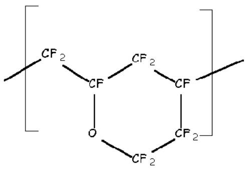 (15)
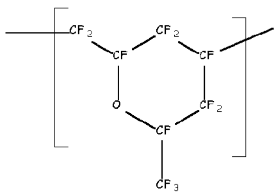 (16)
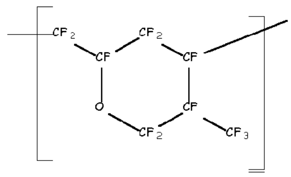 (17)

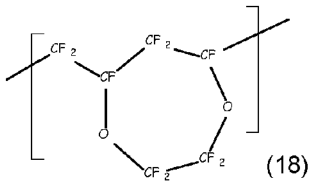 (18)
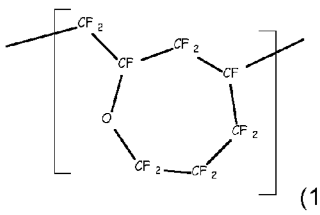 (19).

**5.** Verfahren gemäß Anspruch 3, wobei die von dem Fluormonomer A abgeleitete Wiederholungseinheit Formel 2 entspricht und ausgewählt ist aus der Gruppe bestehend aus jenen, die von den folgenden Formeln 20 bis 30 dargestellt werden:

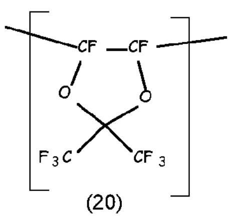 (20)
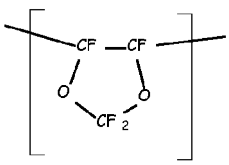 (21)
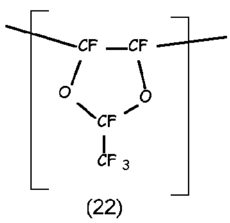 (22)
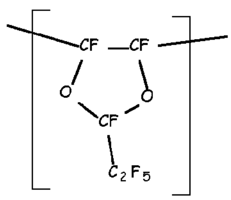 (23)

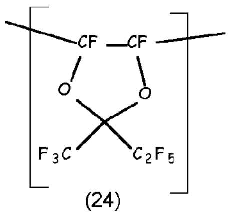
(24)
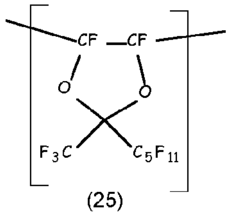
(25)
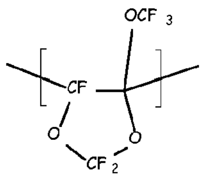
(26)
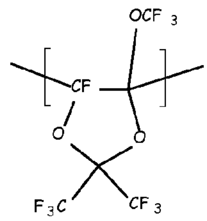
(27)

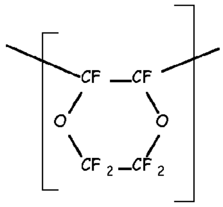
(28)
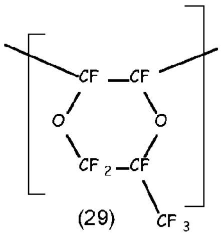
(29)
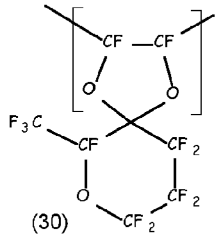
(30)
.

**6.** Verfahren gemäß Anspruch 3, wobei die von dem Fluormonomer A abgeleitete Wiederholungseinheit Formel 3 entspricht und ausgewählt ist aus der Gruppe bestehend aus jenen, die von den folgenden Formeln 31 bis 33 dargestellt werden:

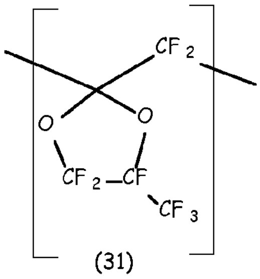
(31)
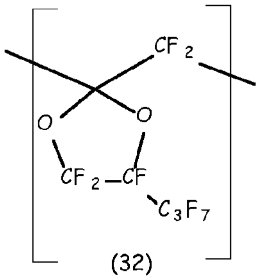
(32)
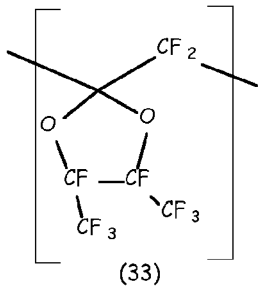
(33)
.

**7.** Verfahren gemäß einem der vorstehenden Ansprüche, wobei das Polymer F Wiederholungseinheiten umfasst, die von wenigstens einem Fluormonomer B abgeleitet sind, das von dem Fluormonomer A verschieden ist, wobei das Fluormonomer B ausgewählt ist aus der Gruppe bestehend aus:

(a) $C_2$-$C_8$-Perfluorolefinen, wie z.B. Tetrafluorethylen "TFE", Hexafluorpropylen "HFP";
(b) Wasserstoff-enthaltenden $C_2$-$C_8$-Fluorolefinen, wie z.B. Vinylidenfluorid "VDF", Vinylfluorid, Trifluorethylen "TrFE", Hexafluorisobutylen "HFIB", Perfluoralkylethylene der Formel $CH_2$=CH-$R_{f1}$, wobei $R_{f1}$ eine $C_1$-$C_6$-Perfluoralkylgruppe ist;
(c) Chlor- und/oder Brom-enthaltenden $C_2$-$C_8$-Fluorolefinen, wie z.B. Chlortrifluorethylen "CTFE";
(d) Perfluoralkylvinylethern "PAVE" der Formel $CF_2$=CFO$R_{f1}$, wobei $R_{f1}$ eine $C_1$-$C_6$-Perfluoralkylgruppe ist, wie z.B. $CF_3$ "PMVE", $C_2F_5$ oder $C_3F_7$;
(e) Perfluoroxyalkylvinylethern der Formel $CF_2$=CFO$X_0$, wobei $X_0$ eine $C_1$-$C_{12}$-Perfluoroxyalkylgruppe ist, die ein oder mehr als ein Ethersauerstoffatom umfasst, einschließlich insbesondere Perfluormethoxyalkylvinylether der Formel $CF_2$=CFO$CF_2$O$R_{f2}$, wobei $R_{f2}$ eine $C_1$-$C_3$-Perfluor(oxy)alkylgruppe ist, wie z.B. -$CF_2CF_3$, -$CF_2CF_2$-O-$CF_3$ und -$CF_3$; und
(f) funktionellen Perfluor(oxy)alkylvinylethern der Formel $CF_2$=CFO$Y_0$, wobei $Y_0$ eine $C_1$-$C_{12}$-Perfluor(oxy)alkylengruppe ist, gegebenenfalls umfassend ein oder mehr als ein Ethersauerstoffatom, umfassend wenigstens eine funktionelle Gruppe ausgewählt aus der Gruppe bestehend aus -$SO_2$X, -COX, -$PO_2$X, wobei X ein Halogen oder eine -O$X_a$-Gruppe ist, wobei $X_a$ H, eine Ammoniumgruppe oder ein Metall-Kation ist.

**8.** Verfahren gemäß Anspruch 7, wobei das Polymer F umfasst:

- von 20 bis 95 mol-%, vorzugsweise von 30 bis 80 mol-%, bevorzugter von 35 bis 50 mol-%, bezogen auf die

Gesamtmolzahl von Wiederholungseinheiten des Polymers (F), an Wiederholungseinheiten mit einer alicyclischen Struktur in der Hauptkette des Fluorpolymers und abgeleitet von wenigstens einem Fluormonomer A; und
- von 5 bis 80 mol-%, vorzugsweise von 20 bis 70 mol-%, bevorzugter von 50 bis 65 mol-%, bezogen auf die Gesamtmolzahl von Wiederholungseinheiten des Polymers F, an Wiederholungseinheiten abgeleitet von wenigstens einem Fluormonomer B, das von Fluormonomer A verschieden ist; und wobei vorzugsweise das Polymer F ein Copolymer ist, das umfasst:
- Wiederholungseinheiten mit einer alicyclischen Struktur in der Hauptkette des Fluorpolymers und abgeleitet von wenigstens einem Fluormonomer A, das perfluoriert ist, und
- Wiederholungseinheiten abgeleitet von wenigstens einem Fluormonomer B, das von Fluormonomer A verschieden ist, das perfluoriert ist.

**9.** Verfahren gemäß Anspruch 8, wobei das Polymer F ein Copolymer ist, das umfasst:

- Wiederholungseinheiten abgeleitet von wenigstens einem Fluormonomer A ausgewählt aus der Gruppe bestehend aus Perfluor(2-methylen-4-methyl-1,3-dioxolan), Perfluor(2,2-dimethyl-1,3-dioxol), Perfluor(1,3-dioxol), 2,2,4-Trifluor-5-trifluormethoxy-1,3-dioxol und Perfluor(3-butenylvinylether); und
- Wiederholungseinheiten abgeleitet von Tetrafluorethylen "TFE",

und wobei das Polymer F vorzugsweise ein Copolymer ist, das umfasst:

- Wiederholungseinheiten abgeleitet von 2,2,4-Trifluor-5-trifluormethoxy-1,3-dioxol; und
- Wiederholungseinheiten abgeleitet von Tetrafluorethylen "TFE".

**10.** Verfahren gemäß einem der vorstehenden Ansprüche, wobei das Polymer F:

- eine Menge an Carboxyl-Endgruppen von höchstens 7,5 mmol/kg, bevorzugter höchstens 7,0 mmol/kg, noch bevorzugter höchstens 6,5 mmol/kg, sogar noch bevorzugter höchstens 6,0 mmol/kg, umfasst, und/oder wobei die Menge an Carboxyl-Endgruppen nicht nachweisbar ist oder wenigstens 0,5 oder sogar wenigstens 1,0 mmol/kg beträgt; und/oder
- eine intrinsische Viskosität von weniger als 25 $cm^3/g$ (cc/g), bevorzugter weniger als 20 $cm^3/g$ (cc/g), und/oder wenigstens 5 $cm^3/g$ (cc/g), vorzugsweise wenigstens 7 $cm^3/g$ (cc/g), bevorzugter wenigstens 10 $cm^3/g$ (cc/g), aufweist.

**11.** Verfahren gemäß einem der vorstehenden Ansprüche, wobei das Lösungsmittel (F) ausgewählt ist aus der Gruppe bestehend aus jenen, die die folgenden Löslichkeitsparameterkomponenten aufweisen:

Dispersionskomponente $\delta_D$ von 11,0 bis 14,50,
polare Komponente $\delta_P$ von 0,1 bis 5,0,
Wasserstoffbrückenkomponente $\delta_H$ von 0,0 bis 2,0.

**12.** Verfahren gemäß Anspruch 11, wobei das Lösungsmittel F ausgewählt ist aus der Gruppe bestehend aus Hydrofluorethern "HFEs", die Ether sind, die eine teilfluorierte Kohlenwasserstoffstruktur umfassen, die sowohl Wasserstoff- als auch Fluoratome an $sp^3$-hybridisierte Kohlenstoffe gebunden umfasst, vorzugsweise ausgewählt aus der Gruppe bestehend aus:

- einem isomeren Gemisch von Methylnonafluorbutylether und Methylnonafluorisobutylether;
- einem isomeren Gemisch von Ethylnonafluorbutylether und Ethylnonafluorisobutylether;
- 3-Ethoxy-1,1,1,2,3,4,4,5,5,6,6,6-dodecafluor-2-trifluormethylhexan;
- 1-Methoxyheptafluorpropan; und
- 1,1,1,2,2,3,4,5,5,5-Decafluor-3-methoxy-4-trifluormethylpentan; und

wobei das Lösungsmittel F höchst bevorzugt 1,1,1,2,2,3,4,5,5,5-Decafluor-3-methoxy-4-trifluormethylpentan ist.

**13.** Verfahren gemäß einem der vorstehenden Ansprüche, wobei das Lösungsmittel P ausgewählt ist aus Lösungsmitteln, deren Löslichkeitsparameter $\delta_T$ wenigstens 20,0 $MPa^{1/2}$ und höchstens 25,5 $MPa^{1/2}$ beträgt, und vorzugsweise ausgewählt ist aus der Gruppe bestehend aus Cyclopentanol, $\delta_T$ = 25,1 $MPa^{1/2}$, PGME, $\delta_T$ = 21,9 $MPa^{1/2}$, und Cyclohexanol, $\delta_T$ = 22,4 $MPa^{1/2}$,

und wobei höchst bevorzugt das Lösungsmittel P Cyclopentanol ist; und/oder
wobei die Menge an Lösungsmittel P von 100 bis 1500 ppm, bezogen auf das Gewicht des Lösungsmittels F, beträgt.

**14.** Verfahren zur Herstellung einer strukturierten Struktur auf einem Substrat, wobei das Verfahren die Schritte umfasst:

(1) Aufbringen einer Zusammensetzung "$C_{LO}$", die wenigstens ein Fluorpolymer umfasst, das umfasst:

- Wiederholungseinheiten, die eine alicyclische Struktur in der Hauptkette des Fluorpolymers aufweisen und von wenigstens einem Fluormonomer A abgeleitet sind, und gegebenenfalls
- Wiederholungseinheiten, die von wenigstens einem Fluormonomer B, das von Fluormonomer A verschieden ist, abgeleitet sind,

wobei das Fluorpolymer:

- eine intrinsische Viskosität von weniger als 30 cc/g, wenn gemessen bei 30 °C in Perfluorhexan als Lösungsmittel, aufweist; und
- eine Menge an Carboxyl-Endgruppen von weniger als 8 mmol/kg umfasst, "Polymer F";

auf wenigstens einen Teil des Substrats, um eine Schicht LO mit der Zusammensetzung "$C_{LO}$", die das Polymer F umfasst, auf dem Substrat zu erhalten;

(2) Strukturieren der Schicht LO, um eine strukturierte Schicht LO zu erhalten, die eine Struktur von bedeckten und unbedeckten Bereichen umfasst;
(3) wenigstens teilweises Entfernen von unbedeckten Bereichen der strukturierten Schicht LO durch Inkontaktbringen mit einem Ablöse-Lösungsmittelgemisch gemäß dem Verfahren gemäß einem der vorstehenden Ansprüche, um eine strukturierte Struktur zu erhalten, die eine Struktur einer Schicht LO auf dem Substrat umfasst.

**15.** Verfahren gemäß Anspruch 14, wobei:

- Schritt (2) umfasst:

einen Teilschritt (2A) des Bildens einer Schicht eines Photoresists auf der Schicht LO, um eine Photoresistschicht zu erhalten;
einen Teilschritt (2B) des Exponierens der Photoresistschicht gegenüber strukturierter Bestrahlung, um eine strukturierte Photoresistschicht zu erhalten, die strahlungsmodifizierte und nicht strahlungsmodifizierte Bereiche umfasst; und
einen Teilschritt (2C) des wesentlichen Entfernens von einem von dem strahlungsmodifizierten und dem nicht strahlungsmodifizierten Bereich, um eine strukturierte Schicht LO zu erhalten, die eine Struktur von Photoresist-bedeckten und nicht Photoresist-bedeckten Bereichen umfasst; und/oder

- das Verfahren einen zusätzlichen Schritt (4) des Aufbringens einer zusätzlichen Beschichtungsschicht aus einem Material (M) auf die strukturierte Struktur, die eine Struktur einer Schicht LO umfasst, auf dem Substrat umfasst, um eine strukturierte Struktur zu erhalten, die eine mit Material (M) beschichtete Struktur der Schicht LO zu erhalten; und einen zusätzlichen nachfolgenden Schritt (5) des Entfernens der Struktur der mit Material (M) beschichteten Struktur der Schicht LO umfassen kann, um eine strukturierte Struktur zu erhalten, die eine entsprechende Negativstruktur der Schicht von Material (M) zu erhalten, wobei das Material (M) ein organisches Halbleitermaterial, ein organometallisches Material, ein biologisches Material und ein metallisches Material sein kann; und/oder wobei das Substrat aus Polyimiden "PI", Polyethylenterephthalat "PET", Polyethylennaphthalat "PEN", Polyetherimid "PEI", Polyamidimid "PAI", Glas, Silicium, Siliciumoxid, transparenten Mischoxiden, wie z.B. Indiumzinnoxiden "ITO", Indiumzinkoxid, aluminiumdotiertem Zinkoxid "AZO", indiumdotiertem Cadmiumoxid; aluminium-, gallium- oder indiumdotiertem Zinkoxid "AZO, GZA oder IZO", Formulierungen, die Kohlenstoffnanoröhrchen, Graphen, Silber-Nanopartikel enthalten; inhärent leitfähigen Polymeren, wie z.B. Polyanilinen, Poly(3,4-ethylendioxythiophen)-Polystyrolsulfonat "PEDOT:PSS", hergestellt sein kann.

## Revendications

**1.** Procédé d'élimination de manière au moins partielle d'une couche de décollement « couche LO » composée d'une

composition « $C_{LO}$ » comprenant au moins un fluoropolymère comprenant :

- des motifs répétitifs d'une structure alicyclique dans la chaîne principale dudit fluoropolymère et issus d'au moins un fluoromonomère A, et, éventuellement,
- un motif répétitif issu d'au moins un fluoromonomère B différent du fluoromonomère A,

ledit fluoropolymère :

- possédant une viscosité intrinsèque inférieure à 30 $cm^3/g$ ($cm^3/g$) lorsqu'elle est mesurée à 30 °C dans du perfluorohexane comme solvant ; et
- comprenant une quantité de groupes terminaux carboxyliques inférieure à 8 mmole/kg de « polymère F » ;

ledit procédé comprenant :

- la fourniture d'un ensemble comprenant un matériau de support ayant des régions couvertes par une couche LO
- la mise en contact dudit ensemble avec un mélange de solvant de strippage comprenant :

  a) au moins un solvant fluoré « solvant F » ayant un paramètre de solubilité d'Hansen $\delta_T$ de moins de 15,0 $MPa^{1/2}$ ;
  b) de 10 à 10 000 ppm, sur la base du poids de solvant F, d'au moins un solvant organique polaire P différent du solvant F, ledit solvant P possédant un paramètre de solubilité d'Hansen $\delta_T$ d'au moins de 20,0 $MPa^{1/2}$ et d'au plus 26,0 $MPa^{1/2}$ ;

de sorte à obtenir une élimination au moins partielle de ladite couche LO.

**2.** Procédé selon la revendication 1, le fluoromonomère A étant choisi dans le groupe constitué par des fluoromonomères ayant une structure alicyclique dans leur forme monomérique et des fluoromonomères qui n'ont pas une structure alicyclique dans leur forme monomérique, mais qui, lors d'une cyclocopolymérisation, fournissent une structure alicyclique dans le motif répétitif résultant du polymère F, et le fluoromonomère A étant un perfluoromonomère.

**3.** Procédé selon la revendication 2, le motif répétitif issu dudit fluoromonomère A étant préférablement représenté par l'une quelconque des formules suivantes 1 à 3 :

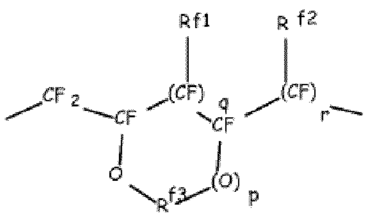
(1)

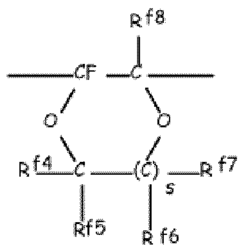
(2)

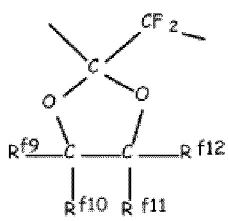
(3)

dans la formule (1) chacun parmi p, q et r qui sont indépendants les uns des autres, étant 0 ou 1, chacun parmi $R^{f1}$ et $R^{f2}$ qui peuvent être les mêmes ou différents, étant un atome de fluor, un groupe $C_1$-$C_5$ perfluoroalkyle ou un groupe $C_1$-$C_5$ perfluoroalcoxy, et $R^{f3}$ étant un groupe $C_1$-$C_3$ perfluoroalkylène, qui peut avoir un groupe $C_1$-$C_5$ perfluoroalkyle ou un groupe $C_1$-$C_5$ perfluoroalcoxy, en tant que substituants ;
dans la formule 2,
s étant 0 ou 1, chacun parmi $R^{f4}$, $R^{f5}$, $R^{f6}$ et $R^{f7}$ qui peuvent être les mêmes ou différents, étant un atome de fluor ou un groupe $C_1$-$C_5$ perfluoroalkyle, et $R^{f8}$ étant un atome de fluor, un groupe $C_1$-$C_5$ perfluoroalkyle ou un groupe $C_1$-$C_5$ perfluoroalcoxy, étant entendu que $R^{f4}$ et $R^{f5}$ peuvent être reliés pour former un cycle spiro lorsque s = 0 ; et
dans la formule (3), chacun parmi $R^{f9}$, $R^{f1°}$, $R^{f11}$ et $R^{f12}$ qui peuvent être les mêmes ou différents, étant un atome de fluor ou un groupe $C_1$-$C_5$ perfluoroalkyle ou un groupe $C_1$-$C_5$ perfluoroalcoxy.

**4.** Procédé selon la revendication 3, le motif répétitif issu dudit fluoromonomère A répondant à la formule 1, et étant

choisi dans le groupe constitué par ceux représentés par les formules suivantes 4 à 19 :

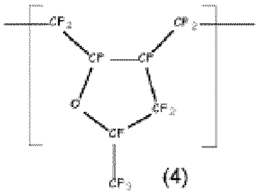
(4)
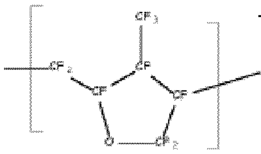
(5)
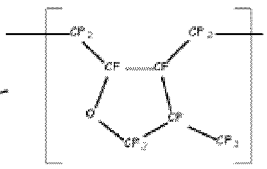
(6)
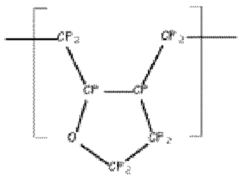
(7)

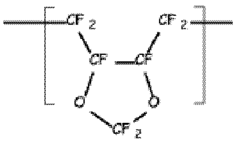
(8)
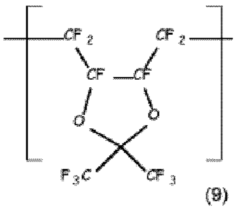
(9)
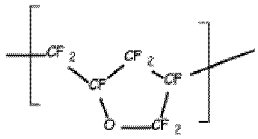
(10)

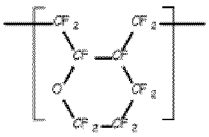
(11)
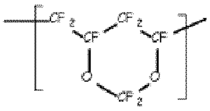
(12)
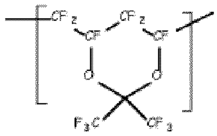
(13)
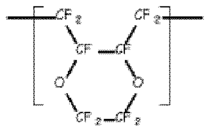
(14)

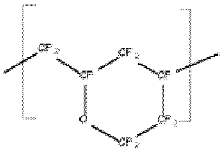
(15)
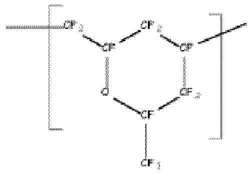
(16)
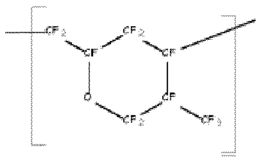
(17)

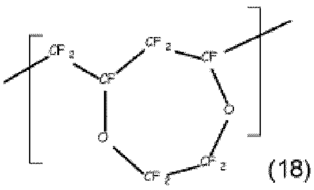
(18)
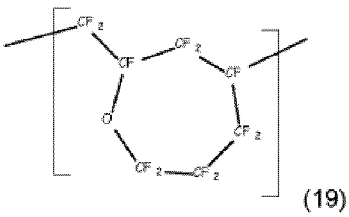
(19)

**5.** Procédé selon la revendication 3, le motif répétitif issu dudit fluoromonomère A répondant à la formule 2, et étant choisi dans le groupe constitué par ceux représentés par les formules suivantes 20 à 30 :

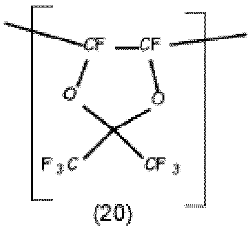
(20)
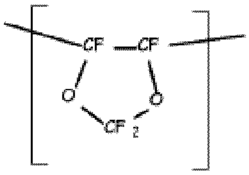
(21)
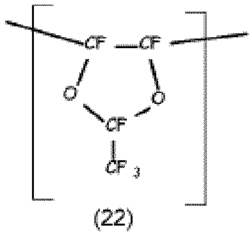
(22)
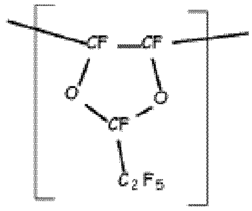
(23)

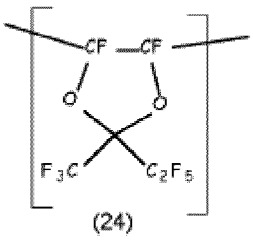
(24)

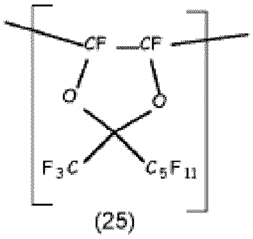
(25)

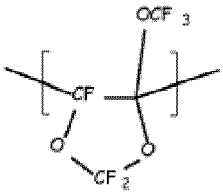
(26)

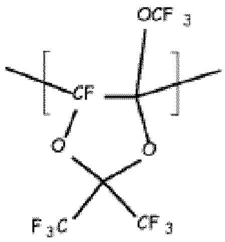
(27)

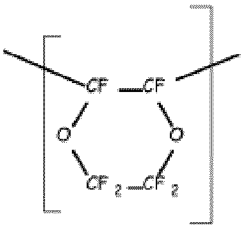
(28)

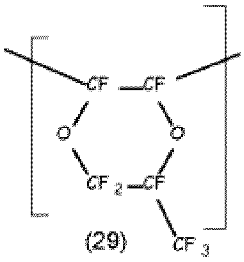
(29)

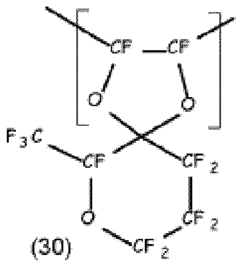
(30)

.

6. Procédé selon la revendication 3, le motif répétitif issu dudit fluoromonomère A répondant à la formule 3, et étant choisi dans le groupe constitué par ceux représentés par les formules suivantes 31 à 33 :

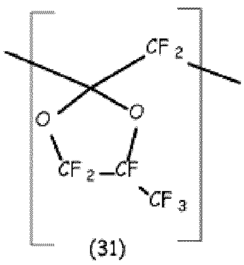
(31)

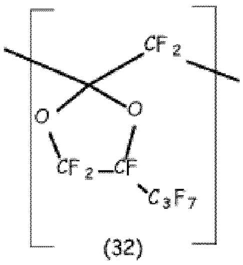
(32)

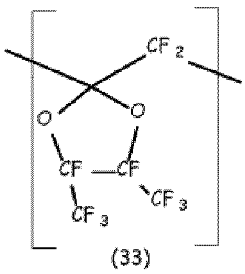
(33)

.

7. Procédé selon l'une quelconque des revendications précédentes, le polymère F comprenant un motif répétitif issu d'au moins un fluoromonomère B différent du fluoromonomère A, le fluoromonomère B étant choisi dans le groupe constitué par :

(a) des $C_2$-$C_8$ perfluorooléfines telles que le tétrafluoroéthylène « TFE », l'hexafluoropropylène « HFP » ;
(b) des $C_2$-$C_8$ fluorooléfines contenant de l'hydrogène, telles que le fluorure de vinylidène « VDF », le fluorure de vinyle, le trifluoroéthylène « TrFE », l'hexafluoroisobutylène « HFIB », des perfluoroalkyléthylènes de formule $CH_2$=CH-$R_{f1}$, $R_{f1}$ étant un groupe $C_1$-$C_6$ perfluoroalkyle ;
(c) des $C_2$-$C_8$ fluorooléfines contenant chloro et/ou bromo telles que le chlorotrifluoroéthylène « CTFE » ;
(d) des perfluoroalkylvinyléthers « PAVE » de formule $CF_2$=$CFOR_{f1}$, $R_{f1}$ étant un groupe $C_1$-$C_6$ perfluoroalkyle, tels que $CF_3$ « PMVE », $C_2F_5$ ou $C_3F_7$ ;
(e) des perfluorooxyalkylvinyléthers de formule $CF_2$=$CFOX_0$, $X_0$ étant un groupe $C_1$-$C_{12}$ perfluorooxyalkyle comprenant un ou plus d'un atome d'oxygène d'éther, y compris notamment des perfluorométhoxyalkylvinyléthers de formule $CF_2$=$CFOCF_2OR_{f2}$, $R_{f2}$ étant un groupe $C_1$-$C_3$ perfluoro (oxy) alkyle, tel que $CF_2CF_3$, -$CF_2CF_2$-O-$CF_3$ et -$CF_3$ ; et
(f) des perfluoro(oxy)alkylvinyléthers fonctionnels de formule $CF_2$=$CFOY_0$, $Y_0$ étant un groupe $C_1$-$C_{12}$ perfluoro(oxy)alkylène, éventuellement comprenant un ou plus d'un atome d'oxygène d'éther, qui comprend au moins un groupe fonctionnel choisi dans le groupe constitué par -$SO_2$X, -COX, -$PO_2$X, X étant un halogène ou un groupe -$OX_a$, $X_a$ étant H, un groupe ammonium ou un cation métallique.

8. Procédé selon la revendication 7, ledit polymère F comprenant :

- de 20 à 95 % en moles, préférablement de 30 à 80 % en moles, plus préférablement de 35 à 50 % en moles, par rapport au nombre total de moles de motifs répétitifs du polymère (F), de motifs répétitifs ayant une structure

alicyclique dans la chaîne principale dudit fluoropolymère et issus d'au moins un fluoromonomère A ; et
- de 5 à 80 % en moles, préférablement de 20 à 70 % en moles, plus préférablement de 50 à 65 % en moles, par rapport au nombre total de moles de motifs répétitifs du polymère F, de motifs répétitifs issus d'au moins un fluoromonomère B différent du fluoromonomère A ; et, préférablement, le polymère F étant un copolymère comprenant :
- des motifs répétitifs ayant une structure alicyclique dans la chaîne principale dudit fluoropolymère et issus d'au moins un fluoromonomère A qui est perfluoré, et
- un motif répétitif issu d'au moins un fluoromonomère B différent du fluoromonomère A, qui est perfluoré.

**9.** Procédé selon la revendication 8, le polymère F étant un copolymère comprenant :

- des motifs répétitifs issus d'au moins un fluoromonomère A choisi dans le groupe constitué par perfluoro(2-méthylène-4-méthyl-1,3-dioxolane), perfluoro(2,2-diméthyl-1,3-dioxole), perfluoro(1,3-dioxole), 2,2,4-trifluoro-5-trifluorométhoxy-1,3-dioxole et perfluoro(éthers de 3-buténylе et de vinyle) ; et
- un motif répétitif issu du tétrafluoroéthylène « TFE »,

et le polymère F étant préférablement un copolymère, comprenant :

- des motifs répétitifs issus du 2,2,4-trifluoro-5-trifluorométhoxy-1,3-dioxole ; et
- un motif répétitif issu du tétrafluoroéthylène « TFE ».

**10.** Procédé selon l'une quelconque des revendications précédentes, ledit polymère F :

- comprenant une quantité de groupes terminaux carboxyliques d'au moins 7,5 mmole/kg, plus préférablement d'au plus 7,0 mmole/kg, encore plus préférablement d'au plus 6,5 mmole/kg, encore plus préférablement d'au plus 6,0 mmole/kg, et/ou la quantité de groupes terminaux carboxyliques n'étant pas détectable ou étant d'au moins 0,5 ou même d'au moins un 1,0 mmole/kg ; et/ou
- possédant une viscosité intrinsèque inférieure à 25 $cm^3/g$ ($cm^3/g$), plus préférablement inférieure à 20 $cm^3/g$ ($cm^3/g$) et/ou d'au moins 5 $cm^3/g$ ($cm^3/g$), préférablement d'au moins 7 $cm^3/g$ ($cm^3/g$), plus préférablement d'au moins 10 $cm^3/g$ ($cm^3/g$).

**11.** Procédé selon l'une quelconque des revendications précédentes, le solvant (F) étant choisi dans le groupe constitué par ceux possédant les composants de paramètre de solubilité suivants :

composant de dispersion, $\delta_D$ de 11,0 à 14,50
composant polaire, $\delta_P$ de 0,1 à 5,0
composant de liaison hydrogène, $\delta_H$ de 0,0 à 2,0.

**12.** Procédé selon la revendication 11, le solvant F étant choisi dans le groupe constitué par des hydrofluoroéthers « HFE » qui sont des éthers comprenant une structure hydrocarbonée partiellement fluorée, comprenant à la fois des atomes d'hydrogène et de fluor liés à des carbones hybridés $sp^3$, et étant préférablement choisi dans le groupe constitué par :

- un mélange isomérique d'éther de méthyle et de nonafluorobutyle et d'éther de méthyle et de nonafluoroisobutyle ;
- un mélange isomérique d'éther d'éthyle et de nonafluorobutyle et d'éther d'éthyle et de nonafluoroisobutyle ;
- 3-éthoxy-1,1,1,2,3,4,4,5,5,6,6,6-dodécafluoro-2-trifluorométhyl-hexane ;
- 1-méthoxyheptafluoropropane ; et
- 1,1,1,2,2,3,4,5,5,5-décafluoro-3-méthoxy-4-trifluorométhylpentane ; et

le solvant F étant le plus préférablement le 1,1,1,2,2,3,4,5,5,5-décafluoro-3-méthoxy-4-trifluorométhylpentane.

**13.** Procédé selon l'une quelconque des revendications précédentes, le solvant P étant choisi parmi des solvants dont le paramètre de solubilité $\delta_T$ est d'au moins 20 $MPa^{1/2}$ et d'au plus 25,5 $MPa^{1/2}$ et étant préférablement choisi dans le groupe constitué par cyclopentanol $\delta_T$ = 25,1 $MPa^{1/2}$, PGME $\delta_T$ = 21,9 $MPa^{1/2}$, et cyclohexanol $\delta_T$ = 22,4 $MPa^{1/2}$

et le plus préférablement le solvant P étant le cyclopentanol ; et/ou
la quantité de solvant P étant de 100 à 1 500 ppm, sur la base du poids de solvant F.

**14.** Procédé pour la production d'une structure à motifs sur un substrat, le procédé comprenant les étapes de :

(1) application d'une composition « $C_{Lo}$ » comprenant au moins un fluoropolymère comprenant :

- des motifs répétitifs d'une structure alicyclique dans la chaîne principale dudit fluoropolymère et issus d'au moins un fluoromonomère A, et, éventuellement,
- un motif répétitif issu d'au moins un fluoromonomère B différent du fluoromonomère A,

ledit fluoropolymère :

- possédant une viscosité intrinsèque inférieure à 30 $cm^3/g$ ($cm^3/g$) lorsqu'elle est mesurée à 30 °C dans du perfluorohexane comme solvant ; et
- comprenant une quantité de groupes terminaux carboxyliques de « polymère F » inférieure à 8 mmole/kg

sur au moins une partie du substrat, de sorte à obtenir une couche de composition LO « $C_{LO}$ » comprenant un polymère F sur ledit substrat ;
(2) structuration de ladite couche LO de sorte à obtenir une couche LO à motifs comprenant un motif de régions couvertes et non couvertes ;
(3) élimination de manière au moins partielle de régions non couvertes de ladite couche LO à motifs, par mise en contact avec un mélange de solvant de strippage selon le procédé selon l'une quelconque des revendications précédentes, de sorte à obtenir une structure à motifs comprenant un motif d'une couche LO sur ledit substrat.

**15.** Procédé selon la revendication 14,

- l'étape (2) comprenant :

une sous-étape (2A) de formation d'une couche d'une photorésine sur ladite couche LO, de sorte à obtenir une couche de photorésine ;
une sous-étape (2B) d'exposition de ladite couche de photorésine à un rayonnement à motifs, de sorte à obtenir une couche de photorésine à motifs comprenant des régions modifiées par un rayonnement et des régions non modifiées par un rayonnement ; et
une sous-étape (2C) d'élimination de manière substantielle soit desdites régions modifiées par un rayonnement et non modifiées par un rayonnement, de sorte à obtenir une couche LO à motifs comprenant un motif de régions couvertes par une photorésine et non couvertes par une photorésine ; et/ou

- le procédé comprenant une étape supplémentaire (4) d'application d'une couche de revêtement supplémentaire d'un matériau (M) sur la structure à motifs comprenant un motif d'une couche LO sur ledit substrat, de sorte à obtenir une structure à motifs comprenant un motif de la couche LO revêtue par un matériau (M) ; et pouvant comprendre une étape subséquente supplémentaire (5) d'élimination dudit motif de la couche LO revêtue par un matériau (M) de sorte à obtenir une structure à motifs comprenant un motif négatif correspondant de couche de matériau (M), le matériau (M) pouvant être un matériau semiconducteur organique, un matériau organométallique, un matériau biologique, et un matériau métallique ; et/ou le substrat pouvant être composé de polyimides « PI », de poly(téréphtalate d'éthylène) « PET », de poly(naphtalate d'éthylène) « PEN », de polyétherimide « PEI », de polyamidimide « PAI », de verre, de silicium, d'oxyde de silicium, d'oxydes mixtes transparents tels que des oxydes d'étain et d'indium « ITO », l'oxyde d'indium et de zinc, l'oxyde de zinc dopé par de l'aluminium « AZO », l'oxyde de cadmium dopé par de l'indium ; l'oxyde de zinc dopé par de l'aluminium, du gallium ou de l'indium « AZO, GZA ou IZO », des formulations contenant des nanotubes de carbone, du graphène, des nanoparticules d'argent ; des polymères intrinsèquement conducteurs tels que des polyanilines, un poly(3,4-éthylènedioxythiophène) poly(sulfonate de styrène) « PEDOT:PSS ».

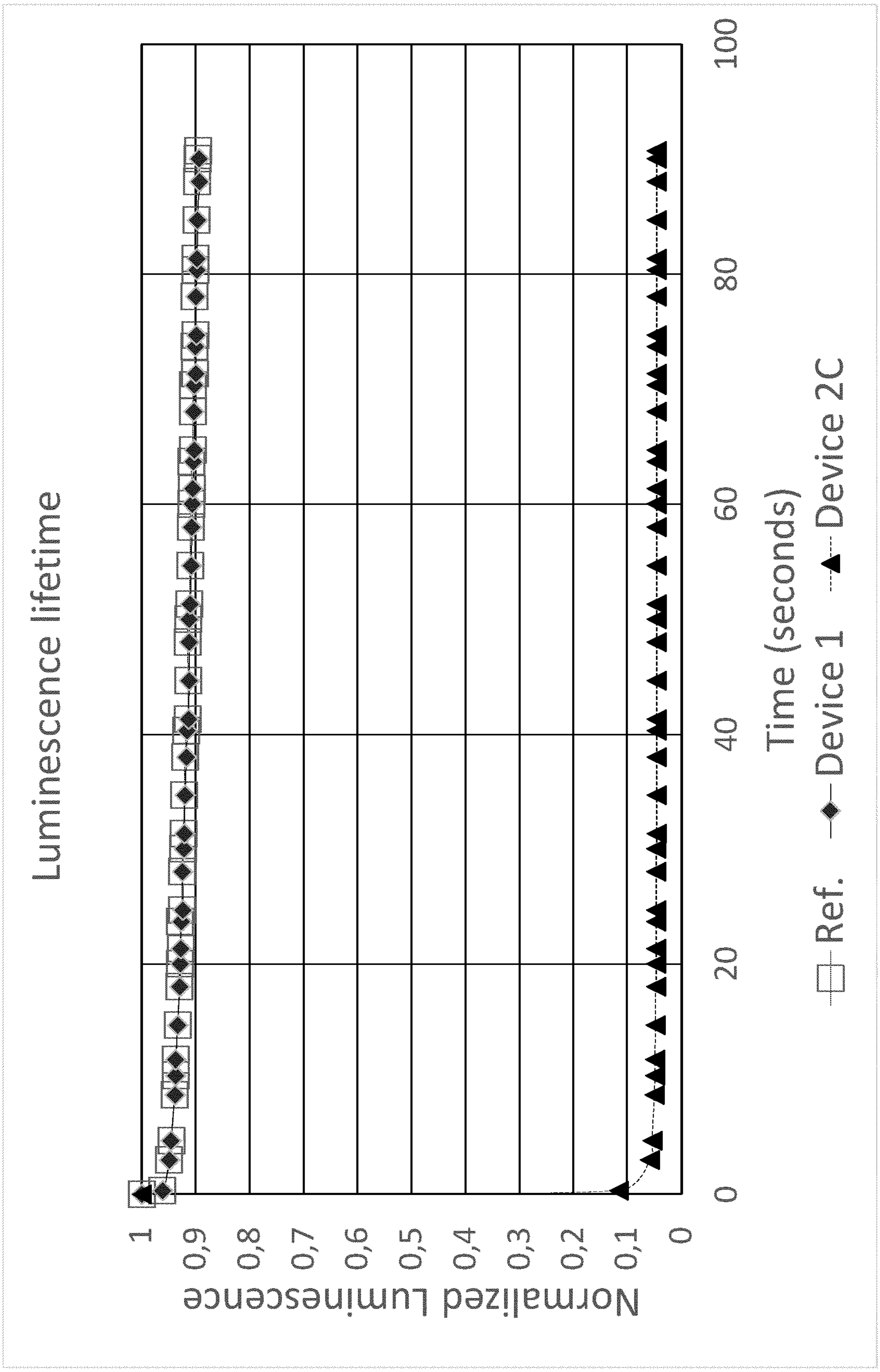
Luminescence lifetime
Normalized Luminescence
1
0,9
0,8
0,7
0,6
0,5
0,4
0,3
0,2
0,1
0
0
20
40
60
80
100
Time (seconds)
Ref.
Device 1
Device 2C

Fig. 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 9899636 B
- US 9768384 B
- US 9091913 B
- WO 2016019273 A1
- WO 2016019212 A1

### Non-patent literature cited in the description

- **PIANCA, M. et al.** End groups in fluoropolymers. *Journal of Fluorine Chemistry.,* 1999, vol. 95, 71-84